# EUROPEAN PATENT APPLICATION

(11) **EP 4 648 104 A1**
(43) Date of publication of application: **12.11.2025**
(21) Application number: 25152235.5
(22) Date of filing: 16.01.2025
(51) Int. Cl.: H01L 23/528, H10D 30/01, H10D 30/00, H10D 84/83, H10D 84/90

(54) **SEMICONDUCTOR DEVICE**

(30) Priority: 07.05.2024 KR 20240059926
(71) Applicant: Samsung Electronics Co., Ltd., Suwon-si, Gyeonggi-do 16677 (KR)
(72) Inventor: PARK, Jisoo, 16677 Suwon-si (KR); LEE, Jung Han, 16677 Suwon-si (KR); KIM, Byung-Sung, 16677 Suwon-si (KR); PARK, Saehan, 16677 Suwon-si (KR); CHUN, Kwanyoung, 16677 Suwon-si (KR)
(74) Representative: Marks & Clerk LLP

(57) **Abstract**

An example semiconductor device includes a lower wiring layer including lower wiring lines, an upper wiring layer including upper wiring lines, and a power gating cell between the lower and upper wiring layers. The power gating cell includes a first active region on a substrate and including first and second lower source/drain patterns and a first channel pattern connecting the first and second lower source/drain patterns with each other, a second active region on the first active region and including first and second upper source/drain patterns, and a power gate electrode surrounding the first channel pattern and extending in a first direction parallel to a top surface of the substrate. The lower wiring layer includes a global power line connected with the first lower source/drain pattern and a local power line connected with the second lower source/drain pattern.

## Description

### BACKGROUND

A semiconductor device includes an integrated circuit consisting of metal oxide semiconductor field effect transistors (MOSFETs). As size and design rule of the semiconductor device are gradually decreased, sizes of the MOSFETs are also increasingly scaled down. The scale down of MOSFETs may deteriorate operating characteristics of the semiconductor device. Accordingly, various research has been conducted to manufacture the semiconductor device having improved performances while overcoming limitations due to integration of the semiconductor device.

### SUMMARY

The present disclosure relates to a semiconductor device having improved electrical properties and increased integration.

The object of the present disclosure is not limited to the mentioned above, and other objects which have not been mentioned above will be clearly understood to those skilled in the art from the following description.

In some implementations, a semiconductor device may include: a lower wiring layer including a plurality of lower wiring lines: an upper wiring layer including a plurality of upper wiring lines; and a power gating cell between the lower wiring layer and the upper wiring layer. The power gating cell may include: a first active region on a substrate, wherein the first active region includes a first lower source/drain pattern, a second lower source/drain pattern, and a first channel pattern that connects the first and second lower source/drain patterns to each other; a second active region on the first active region, wherein the second active region includes a first upper source/drain pattern and a second upper source/drain pattern; and a power gate electrode that surrounds the first channel pattern and extends in a first direction parallel to a top surface of the substrate. The lower wiring layer may include: a global power line connected to the first lower source/drain pattern; and a local power line connected to the second lower source/drain pattern.

In some implementations, a semiconductor device may include: a first active region on a substrate, wherein the first active region includes a first lower source/drain pattern, a second lower source/drain pattern, and a first channel pattern that connects the first and second lower source/drain patterns to each other; a second active region on the first active region, wherein the second active region includes a first upper source/drain pattern and a second upper source/drain pattern; a power gate electrode that extends in a first direction parallel to a top surface of the substrate and surrounds the first channel pattern; a global power line on a bottom surface of the substrate and connected to the first lower source/drain pattern; a first local power line on the bottom surface of the substrate and connected to the second lower source/drain pattern; a through active contact that connects the second lower source/drain pattern to the second upper source/drain pattern; and a second local power line on the top surface of the substrate and connected to the through active contact.

In some implementations, a semiconductor device may include: a first active region on a substrate, wherein the first active region includes a first lower source/drain pattern, a second lower source/drain pattern, and a first channel pattern that connects the first and second lower source/drain patterns to each other; a second active region on the first active region, wherein the second active region includes a first upper source/drain pattern and a second upper source/drain pattern; a power gate electrode that extends in a first direction parallel to a top surface of the substrate and surrounds the first channel pattern; a first separation pattern spaced apart in a second direction from the power gate electrode and in contact with the first lower source/drain pattern; a second separation pattern spaced apart in the second direction from the power gate electrode and in contact with the second lower source/drain pattern and the second upper source/drain pattern; a third separation pattern between the first and second upper source/drain patterns and overlaps the power gate electrode; a dummy gate electrode that extends in the first direction and surrounds a second channel pattern on the first separation pattern; a global power line on a bottom surface of the substrate and connected to the first lower source/drain pattern; a first local power line on the bottom surface of the substrate and connected to the second lower source/drain pattern; a first lower active contact between the global power line and the first lower source/drain pattern; a second lower active contact between the first local power line and the second lower source/drain pattern; a through active contact that connects the second lower source/drain pattern to the second upper source/drain pattern; and a second local power line on the top surface of the substrate and connected to the through active contact.

Details of other implementations are included in the description and drawings.

At least some of the above and other features of the invention are set out in the claims.

### BRIEF DESCRIPTION OF THE DRAWINGS

FIGS. 1 and 2 illustrate example conceptual diagrams showing a logic cell of a semiconductor device.
FIG. 3 illustrates a block diagram showing an example of a semiconductor device including a power gating circuit.
FIG. 4A illustrates a plan view showing an example of a semiconductor device including a power gating cell.
FIG. 4B illustrates a bottom view showing an example of a semiconductor device including a power gating cell.
FIG. 5A illustrates an example cross-sectional view taken along line A-A' of FIGS. 4A and 4B.
FIG. 5B illustrates an example cross-sectional view taken along line B-B' of FIGS. 4A and 4B.
FIG. 5C illustrates an example cross-sectional view taken along line C-C' of FIGS. 4A and 4B.
FIG. 5D illustrates an example cross-sectional view taken along line D-D' of FIGS. 4A and 4B.
FIG. 5E illustrates an example cross-sectional view taken along line E-E' of FIGS. 4A and 4B.
FIG. 6 illustrates a block diagram showing an example of a semiconductor device including a power gating circuit.
FIG. 7A illustrates a plan view showing an example of a semiconductor device including a power gating cell.
FIG. 7B illustrates a bottom view showing an example of a semiconductor device including a power gating cell.
FIG. 8A illustrates an example cross-sectional view taken along line A-A' of FIGS. 7A and 7B.
FIG. 8B illustrates an example cross-sectional view taken along line B-B' of FIGS. 7A and 7B.
FIG. 8C illustrates an example cross-sectional view taken along line C-C' of FIGS. 7A and 7B.
FIG. 8D illustrates an example cross-sectional view taken along line D-D' of FIGS. 7A and 7B.
FIG. 8E illustrates an example cross-sectional view taken along line E-E' of FIGS. 7A and 7B.
FIG. 9A illustrates a plan view showing an example of a semiconductor device including a power gating cell.
FIG. 9B illustrates a bottom view showing an example of a semiconductor device including a power gating cell.
FIG. 10A illustrates an example cross-sectional view taken along line A-A' of FIGS. 9A and 9B.
FIG. 10B illustrates an example cross-sectional view taken along line B-B' of FIGS. 9A and 9B.
FIG. 10C illustrates an example cross-sectional view taken along line C-C' of FIGS. 9A and 9B.
FIG. 10D illustrates an example cross-sectional view taken along line D-D' of FIGS. 9A and 9B.
FIG. 10E illustrates an example cross-sectional view taken along line E-E' of FIGS. 9A and 9B.
FIG. 11 illustrates a bottom view showing an example of a semiconductor device including a power gating cell.
FIG. 12 illustrates an example cross-sectional view taken along line E-E' of FIG. 11.
FIG. 13 illustrates a plan view showing an example of a semiconductor device including a power gating cell.
FIG. 14 illustrates an example cross-sectional view taken along line E-E' of FIG. 13.
FIG. 15 illustrates a plan view showing an example of a semiconductor device including a power gating cell.
FIG. 16 illustrates an example cross-sectional view taken along line B-B' of FIG. 15.
FIG. 17 illustrates an example cross-sectional view taken along line E-E' of FIG. 15.
FIG. 18A illustrates a plan view showing an example of a semiconductor device including a power gating cell.
FIG. 18B illustrates a bottom view showing an example of a semiconductor device including a power gating cell.
FIG. 19A illustrates an example cross-sectional view taken along line A-A' of FIGS. 18A and 18B.
FIG. 19B illustrates an example cross-sectional view taken along line B-B' of FIGS. 18A and 18B.

### DETAILED DESCRIPTION

With reference to drawings, the following will describe in detail a semiconductor device according to some implementations of the present disclosure.

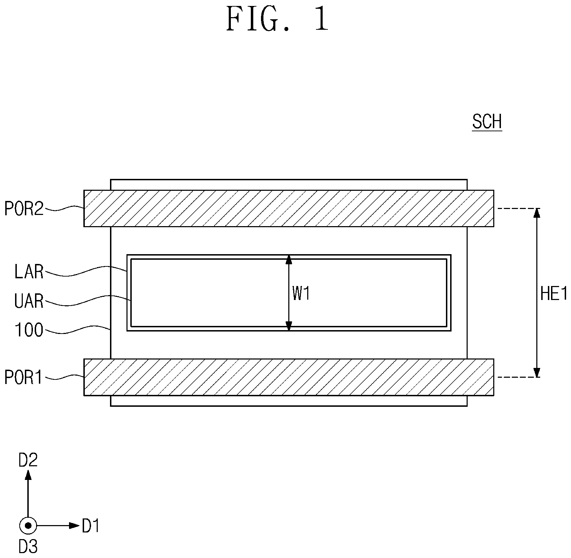

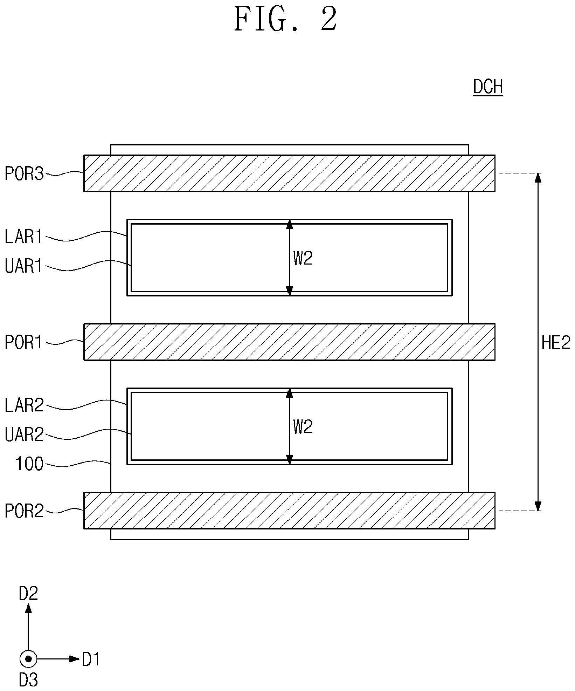

FIGS. 1 and 2 illustrate example conceptual diagrams showing a logic cell of a semiconductor device.

In some implementations, a logic cell may be a unit cell of a layout included in a semiconductor device, may be designed to perform a preset function, and may be called a standard cell. A semiconductor device may include logic cells having various functions. The logic cell may mean a logic device, such as AND, OR, XOR, XNOR, and inverter, that performs a specific function. For example, the logic cell may include transistors for constituting a logic device, and may also include wiring lines that connect the transistors to each other.

The logic cells may include a single height cell SCH and a double height cell DCH.

Referring to FIG. 1, a single height cell SCH may be provided which includes a stacked transistor.

For example, a substrate 100 may be provided thereon with a first power line POR1 and a second power line POR2. The single height cell SCH may be defined between the first power line POR1 and the second power line POR2. The first power line POR1 may be a pathway to which is provided a source voltage, for example, a ground voltage (VSS). The second power line POR2 may be a pathway to which is provided a drain voltage, for example, a power voltage (VDD). The first power line POR1 and the second power line POR2 may extend along a first direction D1 parallel to a top surface of the substrate 100. The first power line POR1 and the second power line POR2 may be spaced apart from each other in a second direction D2 that is parallel to the top surface of the substrate 100 and cross to the first direction D1.

The single height cell SCH may include a lower active region LAR and an upper active region UAR. One of the lower active region LAR and the upper active region UAR may be a PMOSFET region, and the other of the lower active region LAR and the upper active region UAR may be an NMOSFET region.

A semiconductor device may be a three-dimensional device in which transistors are vertically stacked on a front-end-of-line (FEOL) layer.

The upper active region UAR may be stacked on the lower active region LAR in a direction D3 perpendicular to the top surface of the substrate 100. For example, when viewed in a plan view, the upper active region UAR may overlap the lower active region LAR.

A first height HE1 may be defined to indicate a length in the second direction D2 of the single height cell SCH according to some implementations. The first height HE1 may be substantially the same as a distance (e.g., pitch) between the first power line POR1 and the second power line POR2. Each of the lower and upper active regions LAR and UAR may have a first width W1 in the second direction D2. The first width W1 may be less than the first height HE1.

The single height cell SCH according to some implementations may integrate all of NMOSFETs and PMOSFETs in a limited area of the first height HE1. Thus, the semiconductor device may have increased integration.

Referring to FIG. 2, a double height cell DCH may be provided. For example, a substrate 100 may be provided thereon with a first power line POR1, a second power line POR2, and a third power line POR3. The first power line POR1 may be disposed between the second power line POR2 and the third power line POR3. The first power line POR1 may be a pathway to which is provided a source voltage, for example, a ground voltage (VSS). The second power line POR2 and the third power line POR3 may be a pathway to which is provided a drain voltage, for example, a power voltage (VDD). The first power line POR1, the second power line POR2, and the third power line POR3 may extend along a first direction D1 parallel to a top surface of the substrate 100, and may be spaced apart from each other in a second direction D2 that is parallel to the top surface of the substrate 100 and cross to the first direction D1.

The double height cell DCH may be defined between the second power line POR2 and the third power line POR3. The double height cell DCH may include first and second lower active regions LAR1 and LAR2 and first and second upper active regions UAR1 and UAR2.

The first upper active region UAR1 may be provided on the first lower active region LAR1, and the second upper active region UAR2 may be provided on the second lower active region LAR2. For example, when viewed in a plan view, the first lower active region LAR1 may overlap the first upper active region UAR1, and the second lower active region LAR2 may overlap the second upper active region UAR2. The first lower active region LAR1 may be spaced apart from the second lower active region LAR2 in a second direction D2 parallel to the top surface of the substrate 100.

The double height cell DCH according to some implementations may have a second height HE2 in the second direction D2. The second height HE2 may be substantially the same as a distance between the second power line POR2 and the third power line POR3. The second height HE2 may be about twice the first height HE1 of FIG. 1. Each of the first and second upper active regions UAR1 and UAR2 may have a second width in the second direction D2. The second width W2 may be less than half the second height HE2.

In the present disclosure, the double height cell DCH shown in FIG. 2 may be defined as a multi-height cell. Although not shown, the multi-height cell may include a triple height cell whose cell height is about three times that of the single height cell SCH.

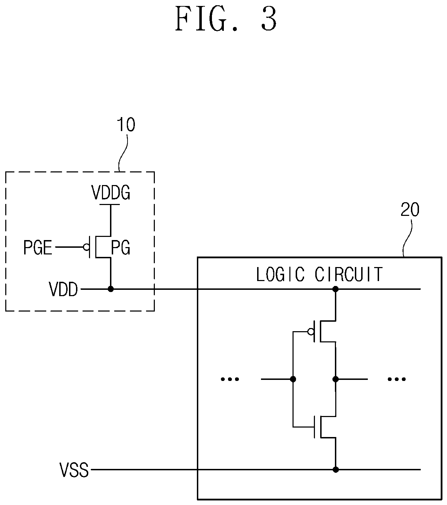

FIG. 3 illustrates a block diagram showing an example of a semiconductor device including a power gating circuit.

Referring to FIG. 3, a semiconductor device may include a power gating circuit 10 and a logic circuit 20.

The power gating circuit 10 may include a PMOS power gating transistor PG connected between a first global power line VDDG and a first power line VDD. In one example, the first global power line VDDG may be referred to as a global power line.

When the logic circuit 20 is in an operating state, the power gating circuit 10 may be turned on to provide the logic circuit 20 with a power voltage.

In response to a control signal PGE, the power gating circuit 10 may selectively connect the first global power line VDDG to the first power line VDD to adjust a power voltage provided to the logic circuit 20 and to adjust a power mode of the logic circuit 20.

In a power-on mode, the power gating circuit 10 may connect the first power line VDD and the first global power line VDDG to each other, thereby providing the logic circuit 20 with a power voltage.

In a power-off mode, the power gating circuit 10 may disconnect the first power line VDD and the first global power line VDDG from each other, thereby electrically floating the first power line VDD.

The power gating circuit 10 may further include a control circuit that provides the power gating transistor PG with a control signal PGE.

The logic circuit 20 may include an arbitrary circuit connected to the first power line VDD. For example, the logic circuit 20 may be achieved as an inverter, a NAND gate, an AND gate, a NOR gate, an OR gate, an XOR gate, an XNOR gate, a multiplexer, an adder, a latch, or a flip-flop.

The logic circuit 20 may be selectively supplied with a power voltage through the first power line VDD. The logic circuit 20 may be provided with a driving voltage whose level is different based on a power mode. For example, the logic circuit 20 may be provided with a power voltage in a power-on mode, and may not be powered in a power-off mode. A semiconductor device according to some implementations may be configured to operate in one or more retention modes in addition to the power-on mode and the power-off mode.

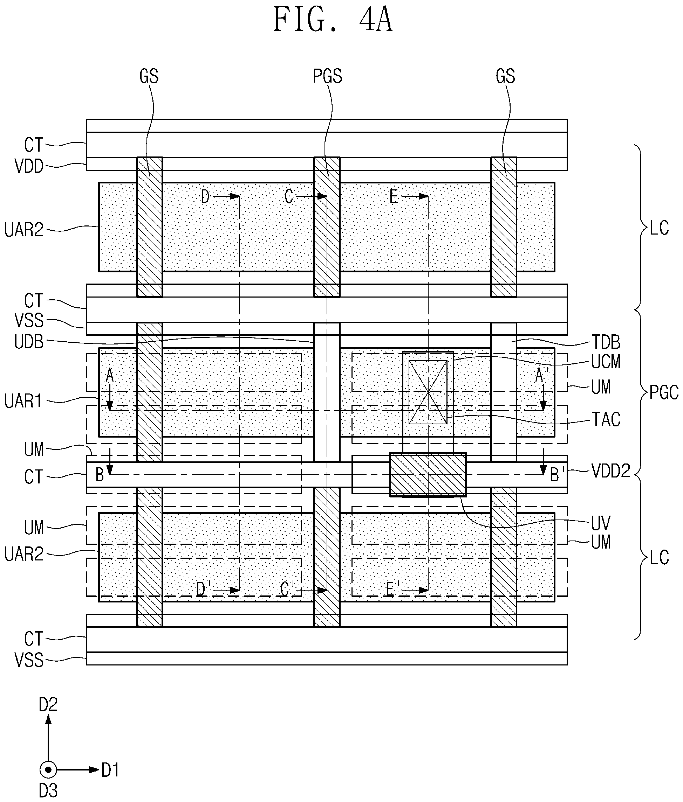

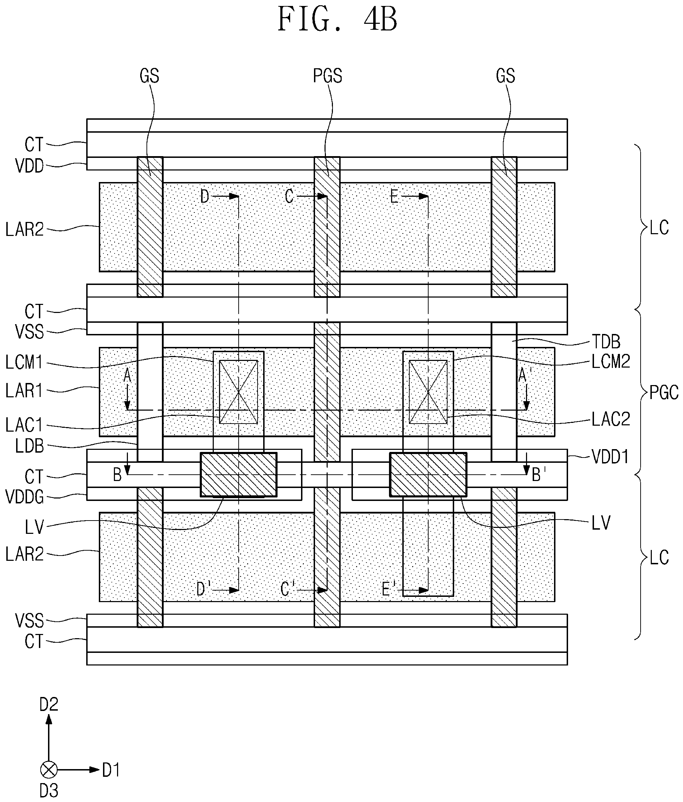

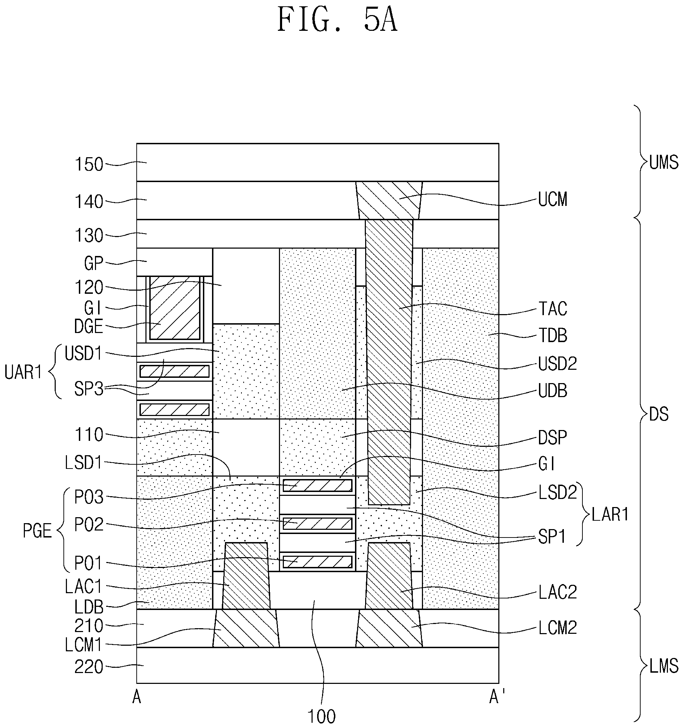

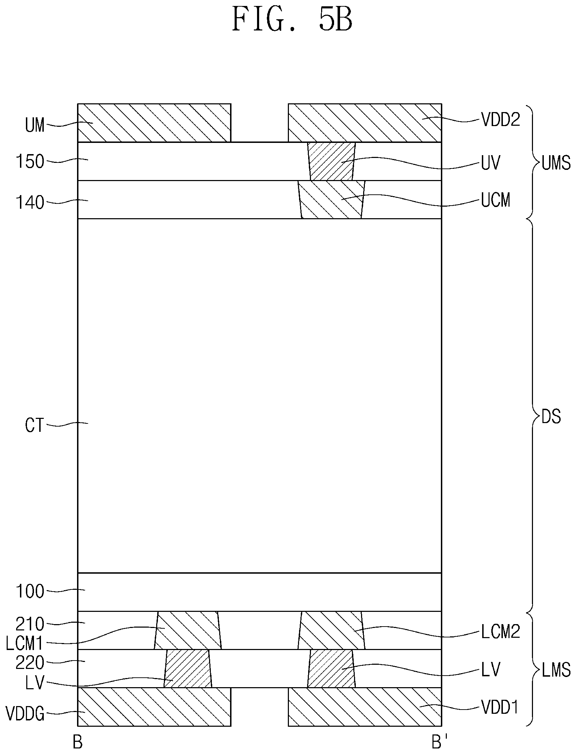

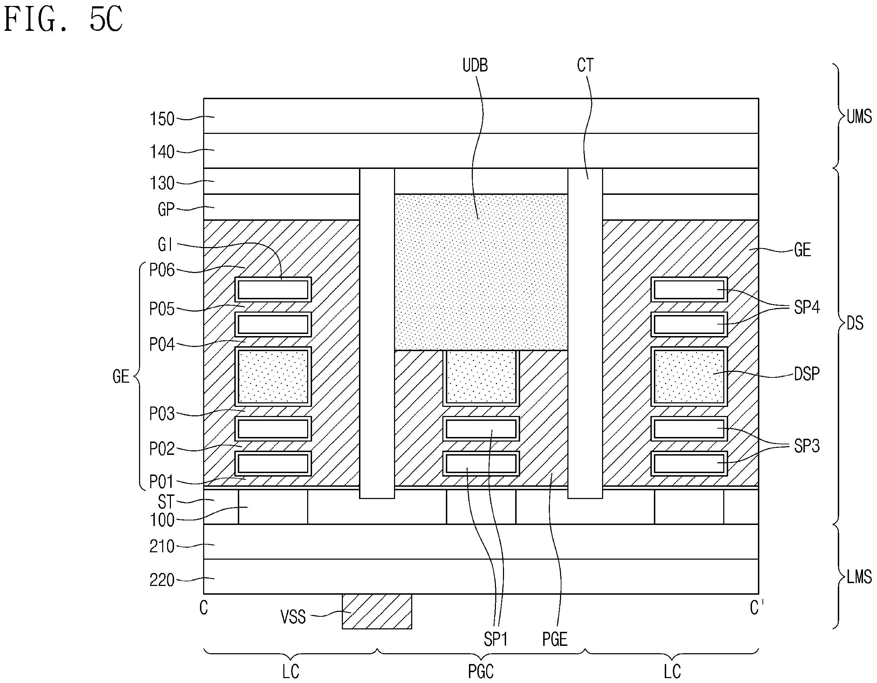

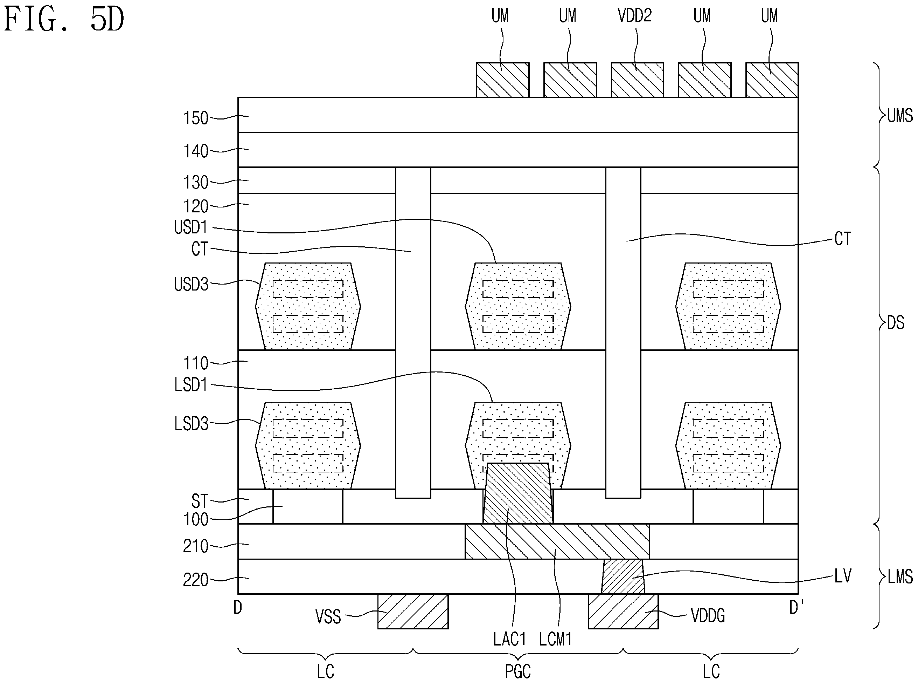

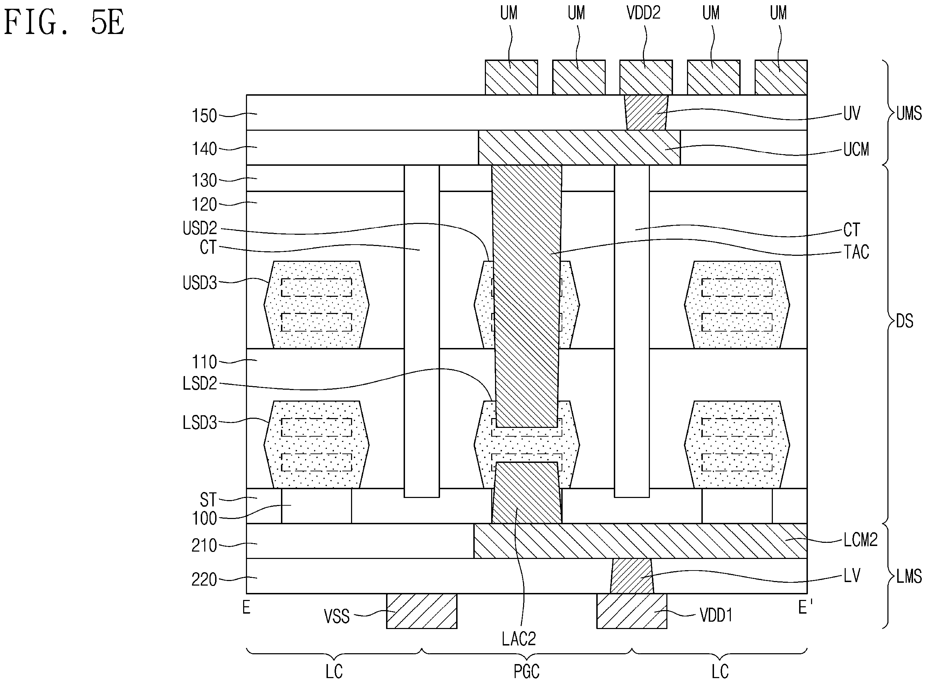

FIG. 4A illustrates a plan view showing an example of a semiconductor device including a power gating cell. FIG. 4B illustrates a bottom view showing an example of a semiconductor device including a power gating cell. FIGS. 5A, 5B, 5C, 5D, and 5E illustrate example cross-sectional views taken along lines A-A', B-B', C-C', D-D', and E-E' of FIGS. 4A and 4B.

Referring to FIGS. 4A, 4B, 5A, 5B, 5C, 5D, and 5E, when viewed in a direction perpendicular to a top surface of a substrate 100, a semiconductor device according to some implementations may include a lower wiring layer LMS including lower wiring lines, an upper wiring layer UMS including upper wiring lines, and a device layer DS disposed between the lower wiring layer LMS and the upper wiring layer UMS.

The substrate 100 may have a top surface and a bottom surface that are opposite to each other. The substrate 100 may be a dielectric substrate including a silicon-based dielectric material (e.g., silicon oxide and/or silicon nitride). Alternatively, the substrate 100 may be a semiconductor substrate including silicon, germanium, or silicon-germanium.

The device layer DS may include logic cells LC and a power gating cell PGC provided on the substrate 100. The logic cells LC and the power gating cell PGC may each be a single height cell discussed above with reference to FIG. 1.

The device layer DS may include a first lower active region LAR1 on the substrate 100 and a first upper active region UAR1 stacked on the first lower active region LAR1.

For example, the first lower active region LAR1 may be a PMOSFET region, and the first upper active region UAR1 may be an NMOSFET region. Alternatively, the first lower active region LAR1 may be an NMOSFET region, and the first upper active region UAR1 may be a PMOSFET region. Each of the first lower active region LAR1 and the first upper active region UAR1 may have a bar or linear shape that extends in a first direction D1.

According to some implementations, the power gating cell PGC may be provided on the first lower active region LAR1 and may be formed of a PMOS transistor. The power gating cell PGC may include a three-dimensional field effect transistor (e.g., MBCFET or GAAFET) in which a power gate electrode PGE three-dimensionally surrounds first channel patterns SP1.

The first lower active region LAR1 may include a first lower source/drain pattern LSD1, a second lower source/drain pattern LSD2, and first channel patterns SP1 that connect the first lower source/drain pattern LSD1 to the second lower source/drain pattern LSD2. In one example, the first lower active region LAR1 may be referred to as a first active region.

The first channel patterns SP1 may be stacked spaced apart from each other in a third direction D3 perpendicular to the top surface of the substrate 100. The first channel patterns SP1 may include silicon (Si), germanium (Ge), or silicon-germanium (SiGe). For example, the first channel patterns SP1 may include crystalline silicon. Each of the first channel patterns SP1 may be a nano-sheet.

The first and second lower source/drain patterns LSD1 and LSD2 may be disposed on the substrate 100. The first lower source/drain pattern LSD1 and the second lower source/drain pattern LSD2 may be spaced apart from each other in the first direction D1 parallel to the top surface of the substrate 100. The first and second lower source/drain patterns LSD1 and LSD2 may be epitaxial patterns formed by a selective epitaxial growth (SEG) process. The first and second lower source/drain patterns LSD1 and LSD2 may include impurities having a first conductivity type. For example, the first and second lower source/drain patterns LSD1 and LSD may include p-type impurities. The first and second lower source/drain patterns LSD1 and LSD2 may include one or more of silicon (Si) and silicon-germanium (SiGe).

A first interlayer dielectric layer 110 may be provided on the first and second lower source/drain patterns LSD1 and LSD2. The first interlayer dielectric layer 110 may cover the first and second lower source/drain patterns LSD1 and LSD2.

The first upper active region UAR1 may include a first upper source/drain pattern USD1 and a second upper source/drain pattern USD2. The first upper source/drain pattern USD1 and the second upper source/drain pattern USD2 may be spaced apart from each other in the first direction D1 parallel to the top surface of the substrate 100. The first interlayer dielectric layer 110 may separate the first and second upper source/drain patterns USD1 and USD2 from the first and second lower source/drain patterns LSD1 and LSD2. In one example, the first upper active region LAR2 may be referred to as a second active region.

The first and second upper source/drain patterns USD1 and USD2 may be disposed on the first interlayer dielectric layer 110. The first and second upper source/drain patterns USD1 and USD2 may impurities having a second conductivity type. For example, the first and second upper source/drain patterns USD1 and USD2 may include n-type impurities. The first and second upper source/drain patterns USD1 and USD2 may include one or more of silicon (Si) and silicon-germanium (SiGe). A second interlayer dielectric layer 120 may be disposed on the first and second upper source/drain patterns USD1 and USD2. The second interlayer dielectric layer 120 may cover the first and second upper source/drain patterns USD1 and USD2.

A power gate structure PGS may extend in a second direction D2 and cross the first lower active region LAR1 and the first upper active region UAR1. The power gate structure PGS may include a power gate electrode PGE, an upper separation pattern UDB on the power gate electrode PGE, a dummy pattern DSP between the power gate electrode PGE and the upper separation pattern UDB, and a gate dielectric layer GI.

The power gate electrode PGE may extend along the second direction D2 parallel to the top surface of the substrate 100, and may surround the first channel patterns SP1 that are vertically stacked on the substrate 100. For example, portions of the power gate electrode PGE may be interposed between the first channel patterns SP1. The power gate electrode PGE may include a first inner electrode PO1 interposed between the substrate 100 and the first channel pattern SP1, a second inner electrode PO2 interposed between neighboring first channel patterns SP1, and a third inner electrode PO3 interposed between the first channel pattern SP1 and the dummy pattern DSP.

The dummy pattern DSP may be vertically spaced apart from and overlap the first channel patterns SP1. The dummy pattern DSP may include a semiconductor material such as silicon (Si), germanium (Ge), or silicon-germanium (SiGe), or a silicon-based dielectric material such as silicon oxide or silicon nitride. In some implementations, the dummy pattern DSP may include a silicon-based dielectric material.

The upper separation pattern UDB may extend in the second direction D2 on the dummy pattern DSP. The upper separation pattern UDB may overlap the power gate electrode PGE. The upper separation pattern UDB may be disposed between the first upper source/drain pattern USD1 and the second upper source/drain pattern USD2. Opposite sidewalls of the upper separation pattern UDB may be in contact with the first upper source/drain pattern USD1 and the second upper source/drain pattern USD2. The upper separation pattern UDB may include a dielectric material, such as at least one selected from silicon oxide, silicon oxycarbide, silicon nitride, and a combination thereof. In one example, the upper separation pattern UDB may be referred to as a third separation pattern.

The gate dielectric layer GI may be interposed between the power gate electrode PGE and the first channel patterns SP1. In addition, a portion of the gate dielectric layer GI may be interposed between the power gate electrode PGE and the dummy pattern DSP. The gate dielectric layer GI may include one or more of a silicon oxide layer, a silicon oxynitride layer, and a high-k dielectric layer. In some implementations, the gate dielectric layer GI may include a silicon oxide layer that directly covers surfaces of the first channel patterns SP1 and a high-k dielectric layer on the silicon oxide layer. For example, the gate dielectric layer GI may include a multi-layer of a silicon oxide layer and a high-k dielectric layer.

The high-k dielectric layer may include a high-k dielectric material whose dielectric constant is greater than that of a silicon oxide layer. For example, the high-k dielectric material may include at least one selected from hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

On the top surface of the substrate 100, a lower separation pattern LDB may be in contact with the first lower source/drain pattern LSD1. The lower separation pattern LDB may be spaced apart in the first direction D1 from the power gate electrode PGE, and may be parallel in the second direction D2 to the power gate electrode PGE. The lower separation pattern LDB may include a dielectric material, such as at least one selected from silicon oxide, silicon oxycarbide, silicon nitride, and a combination thereof. In one example, the lower separation pattern LDB may be referred to as a first separation pattern.

Third channel patterns SP3 may be stacked spaced apart from each other in the third direction D3 on the lower separation pattern LDB. The third channel patterns SP3 may include silicon (Si), germanium (Ge), or silicon-germanium (SiGe). For example, the third channel patterns SP3 may include crystalline silicon. Each of the third channel patterns SP3 may be a nano-sheet.

A dummy gate electrode DGE may be disposed on the lower separation pattern LDB. The dummy gate electrode DGE may surround the third channel patterns SP3, and may overlap the lower separation pattern LDB. A portion of the dummy gate electrode DGE may be interposed between the dummy pattern DSP and the third channel pattern SP3 and between neighboring third channel patterns SP3. An upper portion of the dummy gate electrode DGE may be disposed on an uppermost third channel pattern SP3.

The dummy pattern DSP may be disposed between the lower separation pattern LDB and the dummy gate electrode DGE.

A pair of gate spacers may be disposed on opposite sidewalls of the dummy gate electrode DGE. The gate spacers may extend in the first direction D1 along the dummy gate electrode DGE. The gate spacers may include one at least one selected from SiCN, SiCON, and SiN. Alternatively, the gate spacers may include a multi-layer formed of at least two selected from SiCN, SiCON, and SiN.

A gate capping pattern GP may be provided on a top surface of the dummy gate electrode DGE. The gate capping pattern GP may extend in the first direction D1 along the dummy gate electrode DGE. For example, the gate capping pattern GP may include at least one selected from SiON, SiCN, SiCON, and SiN.

On the top surface of the substrate 100, a through separation pattern TDB may be in contact with the second lower source/drain pattern LSD2. The through separation pattern TDB may be spaced apart in the first direction D1 from the power gate electrode PGE, and may be parallel in the second direction D2 to the power gate electrode PGE. The through separation pattern TDB may extend in the third direction D3, and may be in contact with the second upper source/drain pattern USD2. The through separation pattern TDB may include a dielectric material, such as at least one selected from silicon oxide, silicon oxycarbide, silicon nitride, and a combination thereof. In one example, the through separation pattern TDB may be referred to as a second separation pattern. In one example, the second separation pattern may extend vertically and may contact the second upper source/drain pattern.

A third interlayer dielectric layer 130 may be provided on the second interlayer dielectric layer 120. A through active contact TAC may vertically penetrate the third interlayer dielectric layer 130, the second interlayer dielectric layer 120, the second upper source/drain pattern USD2, and the first interlayer dielectric layer 110, and may be connected to the second lower source/drain pattern LSD2. The through active contact TAC may electrically connect the second upper source/drain pattern USD2 to the second lower source/drain pattern LSD2. The second upper source/drain pattern USD2 may be partially in direct contact with a sidewall of the through active contact TAC. The through active contact TAC may be disposed between the upper separation pattern UDB and the through separation pattern TDB. The through active contact TAC may include metal selected from copper (Cu), aluminum (Al), ruthenium (Ru), cobalt (Co), tungsten (W), and molybdenum (Mo).

A device isolation layer ST may be provided in the substrate 100. The device isolation layer ST may define the lower and upper active regions LAR1, LAR2, UAR1, and UAR2. For example, the device isolation layer ST may include a silicon-based dielectric material (e.g., silicon oxide, silicon oxynitride, or silicon nitride).

First and second lower active contacts LAC1 and LAC2 may penetrate the substrate 100 to be coupled to the first and second lower source/drain patterns LSD1 and LSD2, respectively. The first and second lower active contacts LAC1 and LAC2 may be buried in the substrate 100. The first and second lower active contacts LAC1 and LAC2 may include metal selected from copper (Cu), aluminum (Al), ruthenium (Ru), cobalt (Co), tungsten (W), and molybdenum (Mo).

The lower wiring layer LMS may be provided on the bottom surface of the substrate 100, and may include first and second lower power lines VSS and VDD, a first global power line VDDG, and a first local power line VDD1. In one example, the first local power line VDD1 may be referred to as a local power line.

The first and second lower power lines VSS and VDD may parallel extend along the first direction D1. The first global power line VDDG and the first local power line VDD1 may extend along the first direction D1. When viewed in a plan view, the first global power line VDDG and the first local power line VDD1 may be spaced apart from each other in the first direction D1 across the power gate structure PGS.

The lower wiring layer LMS may further include first and second lower interlayer dielectric layers 210 and 220, first and second lower connection patterns LCM1 and LCM2 that are stacked on the bottom surface of the substrate 100.

The first and second lower connection patterns LCM1 and LCM2 may be disposed in the first lower interlayer dielectric layer 210, and may have a bar shape with a major axis in the second direction D2.

The first lower connection pattern LCM1 may be coupled to the first lower active contact LAC1, and the second lower connection pattern LCM2 may be coupled to the second lower active contact LAC2.

The first global power line VDDG may extend in the first direction D1 on the second lower interlayer dielectric layer 220, and may be connected through a lower via LV to the first lower connection pattern LCM1.

In one implementation, the first global power line VDDG may be connected with the first lower source/drain pattern LSD1. In one implementation, the local power line VDD1 may be connected with the second lower source/drain pattern LSD2.

On the second lower interlayer dielectric layer 220, the first local power line VDD1 may be disposed spaced apart in the first direction D1 from the first global power line VDDG, and may extend along the first direction D1. The first local power line VDD1 may be connected through a lower via LV to the second lower connection pattern LCM2.

The upper wiring layer UMS may be provided on the second interlayer dielectric layer 120, the power gate structure PGS, and gate structures GS, and may include upper wiring lines UM and a second local power line VDD2. The upper wiring layer UMS may include sequentially stacked third, fourth, and fifth interlayer dielectric layers 130, 140, and 150, an upper connection pattern UCM, an upper via UV, upper wiring lines UM, and a second local power line VDD2.

The upper connection pattern UCM may be disposed in the fourth interlayer dielectric layer 140, and may be connected to the through active contact TAC. The upper connection pattern UCM may have a bar shape with a major axis in the second direction D2.

The upper via UV may be disposed in the fifth interlayer dielectric layer 150, and may be coupled to the upper connection pattern UCM.

The upper wiring lines UM may be disposed at a regular pitch on the fifth interlayer dielectric layer 150. When viewed in a plan view, the upper wiring lines UM may be disposed between the first and second lower power lines VSS and VDD.

The second local power line VDD2 may have the same line-width as that of the upper wiring lines UM, and may be spaced apart in the first and second directions D1 and D2 from the upper wiring lines UM. The second local power line VDD2 may be electrically connected through the upper via UV to the upper connection pattern UCM. For example, the second local power line VDD2 may be electrically connected through the upper via UV, the upper connection pattern UCM, and the through active contact TAC to the second lower source/drain pattern LSD2 of the power gating cell PGC.

The logic cells LC may be provided spaced apart in the second direction D2 from the power gating cell PGC.

A cutting pattern CT may separate the power gating cell PGC and the logic cells LC adjacent in the second direction D2. Neighboring cutting patterns CT may have a bar or linear shape that extends in the first direction D1.

The logic cells LC may include a second lower active region LAR2 on the substrate 100, a second upper active region UAR2 stacked on the second lower active region LAR2, and a gate electrode GE.

The logic cells LC may include a three-dimensional field effect transistor (e.g., MBCFET or GAAFET) in which the gate electrode GE three-dimensionally surrounds the third and fourth channel patterns SP3 and SP4.

For example, the second lower active region LAR2 may be a PMOSFET region, and the second upper active region UAR2 may be an NMOSFET region. Alternatively, the second lower active region LAR2 may be an NMOSFET region, and the second upper active region UAR2 may be a PMOSFET region. Each of the second lower and upper active regions LAR2 and UAR2 may have a bar or linear shape that extends in the first direction D1.

The second lower active region LAR2 may include third lower source/drain patterns LSD3 spaced apart from each other in the first direction D1, and may also include third channel patterns SP3 that connect the third lower source/drain patterns LSD3 to each other.

The second upper active region UAR2 may include third upper source/drain patterns USD3 spaced apart from each other in the first direction D1, and may also include fourth channel patterns SP4 that connect the third upper source/drain patterns USD3 to each other. The dummy pattern DSP may be disposed between a lowermost fourth channel pattern SP4 and an uppermost third channel pattern SP3.

The gate electrode GE may extend in the second direction D2, while surrounding the third channel patterns SP3 and the fourth channel patterns SP4.

The gate electrode GE may include a first inner electrode PO1 interposed between the third channel pattern SP3 and the substrate 100, a second inner electrode PO2 interposed between the third channel patterns SP3, a third inner electrode PO3 interposed between the third channel pattern SP3 and the dummy pattern DSP, a fourth inner electrode PO4 between the dummy pattern DSP and the fourth channel pattern SP4, a fifth inner electrode PO5 interposed between the fourth channel patterns SP4, and an outer electrode PO6 on the fourth channel pattern SP4.

A gate capping pattern GP may be provided on a top surface of the gate electrode GE. The gate capping pattern GP may extend in the first direction D1 along the gate electrode GE. A gate dielectric layer GI may be interposed between the gate electrode GE and the third and fourth channel patterns SP3 and SP4.

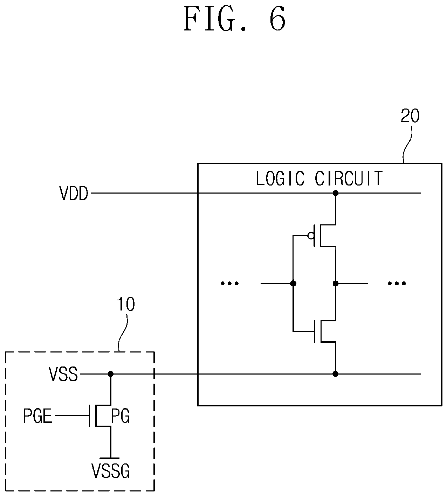

FIG. 6 illustrates a block diagram showing an example of a semiconductor device including a power gating circuit.

Referring to FIG. 6, a semiconductor device may include a power gating circuit 10 and a logic circuit 20. Differently from the implementations discussed with reference to FIG. 3, the power gating circuit 10 illustrated in FIG. 6 may include an NMOS power gating transistor PG connected between a second global power line VSSG and a second power line VSS.

When the logic circuit 20 is in an operating state, the power gating circuit 10 may be turned on to provide the logic circuit 20 with a power voltage. In response to a control signal PGE, the power gating circuit 10 may selectively connect the second global power line VSSG to the second power line VSS to adjust a ground voltage provided to the logic circuit 20 and to adjust a power mode of the logic circuit 20.

In a power-on mode, the power gating circuit 10 may connect the second global power line VSSG to the second power line VSS, thereby providing the logic circuit 20 with a ground voltage.

In a power-off mode, the power gating circuit 10 may disconnect the second global power line VSSG from the second power line VSS, thereby electrically floating the second power line VSS.

The power gating circuit 10 may further include a control circuit that provides the power gating transistor PG with a control signal PGE.

The logic circuit 20 may include an arbitrary circuit connected to the second power line VSS. For example, the logic circuit 20 may be achieved as an inverter, a NAND gate, an AND gate, a NOR gate, an OR gate, an XOR gate, an XNOR gate, a multiplexer, an adder, a latch, or a flip-flop.

In some implementations, it is illustrated that the power gating circuit 10 is formed of a PMOS or NMOS transistor, in other implementations, the power gating circuit 10 may include both of a PMOS power gating transistor and an NMOS power gating transistor.

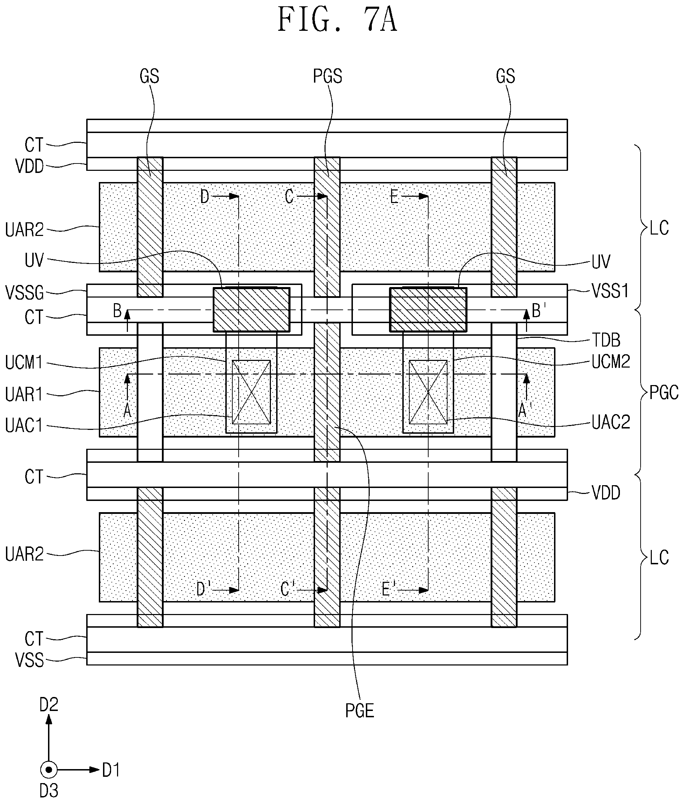

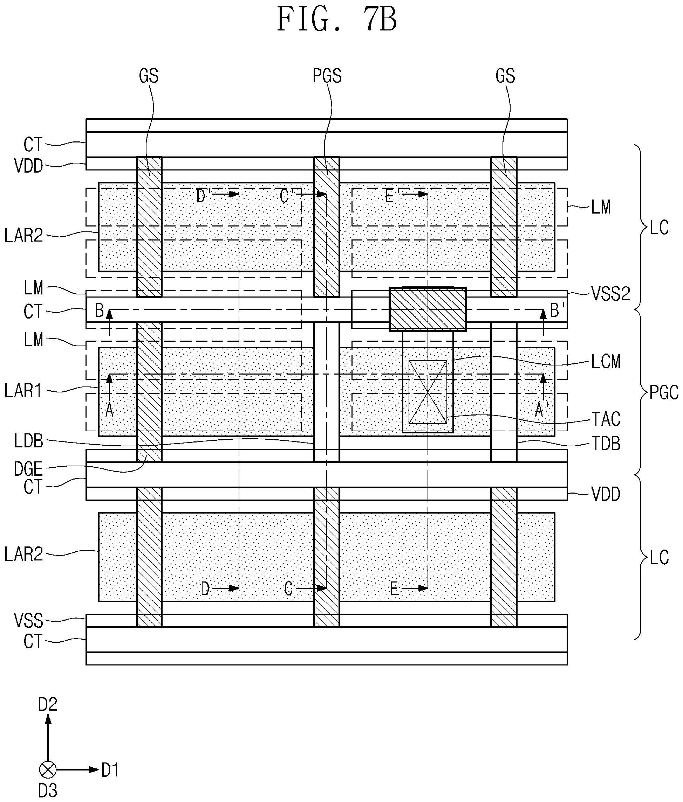

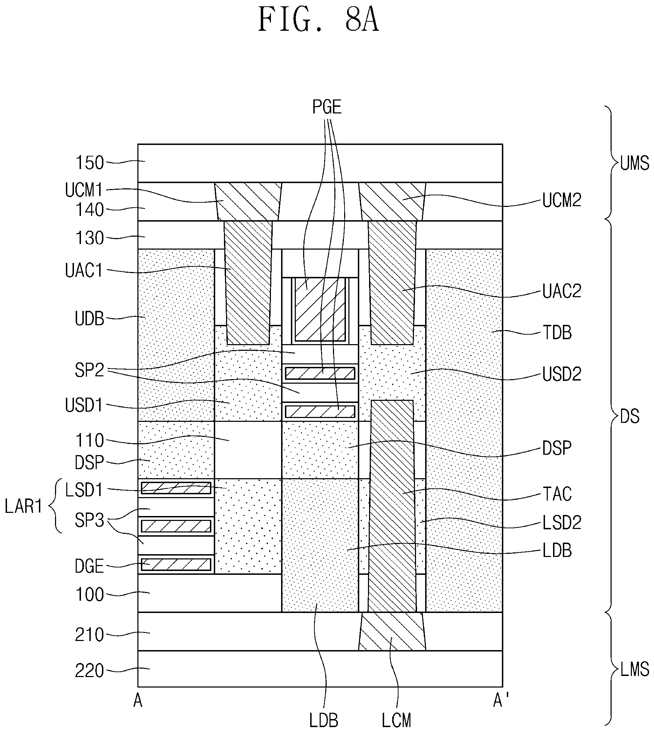

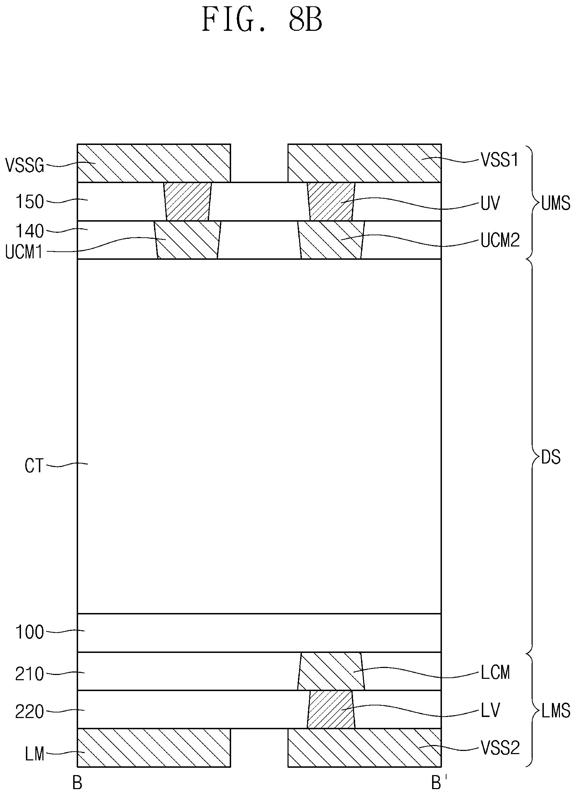

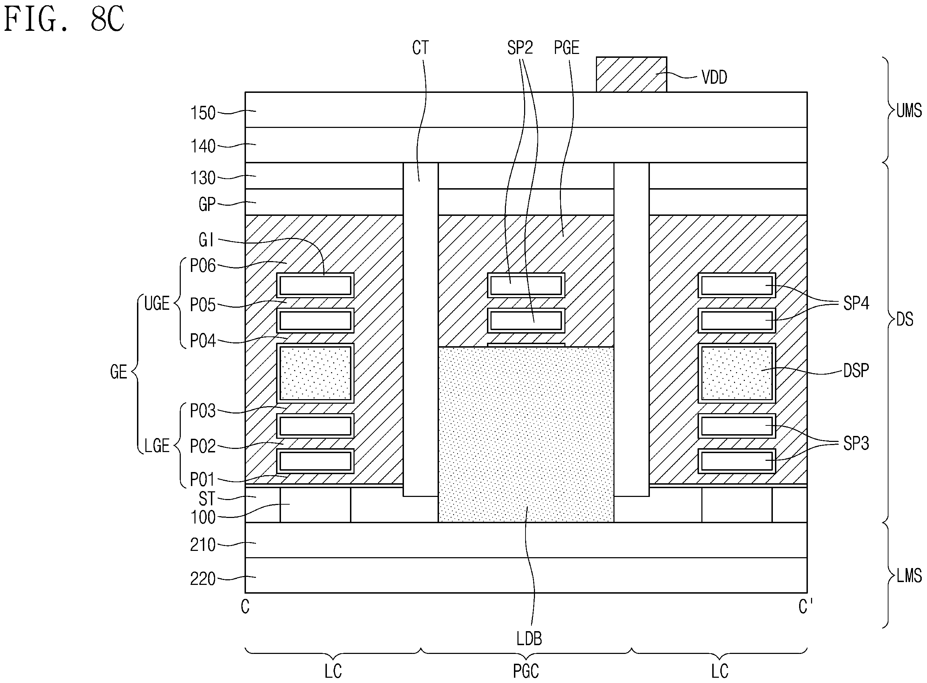

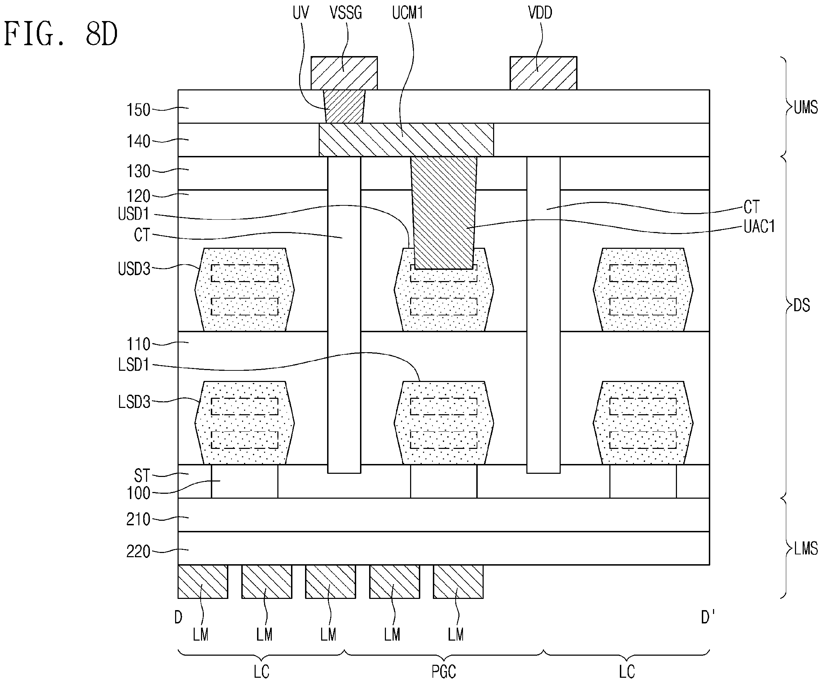

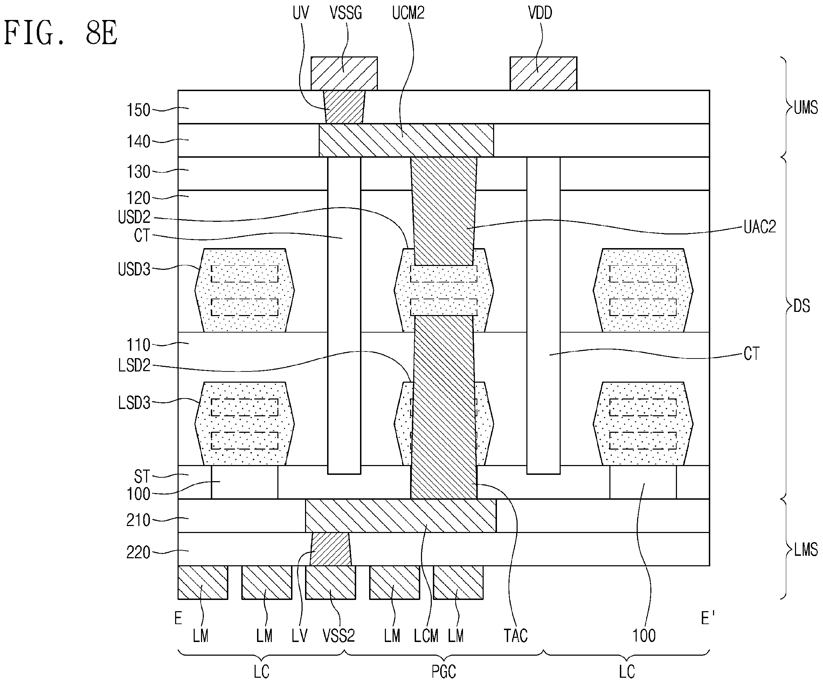

FIG. 7A illustrates a plan view showing an example of a semiconductor device including a power gating cell. FIG. 7B illustrates a bottom view showing an example of a semiconductor device including a power gating cell. FIGS. 8A, 8B, 8C, 8D, and 8E illustrate example cross-sectional views taken along lines A-A', B-B', C-C', D-D', and E-E' of FIGS. 7A and 7B. The components repetitive to those discussed above with reference to FIGS. 4A, 4B, and 5A to 5E will be allocated the same reference numerals, and a detailed description of related technical features thereof will be omitted.

Referring to FIGS. 7A, 7B, and 8A to 8E, the power gating cell PGC may be provided between the logic cells LC. The power gating cell PGC may include a first lower active region LAR1 on the substrate 100, a first upper active region UAR1 stacked on the first lower active region LAR1, and a power gate electrode PGE. For example, the first lower active region LAR1 may be a PMOSFET region, and the first upper active region UAR1 may be an NMOSFET region. According to some implementations, the power gating cell PGC may be provided on the first upper active region UAR1 and may be formed of an NMOS transistor.

The first lower active region LAR1 may include a first lower source/drain pattern LSD1, a second lower source/drain pattern LSD2, and a lower separation pattern LDB between the first lower source/drain pattern LSD1 and the second lower source/drain pattern LSD2.

The first lower source/drain pattern LSD1 and the second lower source/drain pattern LSD2 may be spaced apart from each other in the first direction D1 parallel to a top surface of the substrate 100, and may be in contact with a sidewall of the lower separation pattern LDB.

The first upper active region UAR1 may include a first upper source/drain pattern USD1, a second upper source/drain pattern USD2, a second channel patterns SP2 that connect the first and second upper source/drain patterns USD1 and USD2 to each other, and the power gate electrode PGE.

The second channel patterns SP2 may be stacked spaced apart from each other in the third direction D3 on the dummy pattern DSP. The second channel patterns SP2 may include silicon (Si), germanium (Ge), or silicon-germanium (SiGe). For example, the second channel patterns SP2 may include crystalline silicon. Each of the second channel patterns SP2 may be a nano-sheet.

The first interlayer dielectric layer 110 may separate the first and second upper source/drain patterns USD1 and USD2 from the first and second lower source/drain patterns LSD1 and LSD2.

For example, the first and second lower source/drain patterns LSD1 and LSD may include p-type impurities. The first and second upper source/drain patterns USD1 and USD2 may include n-type impurities.

The power gate structure PGS may extend in the second direction D2 and cross the first lower and upper active regions LAR1 and UAR1. The power gate structure PGS may include the power gate electrode PGE on the lower separation pattern LDB.

The power gate electrode PGE may extend along the first direction D1 parallel to the top surface of the substrate 100, and may surround the second channel patterns SP2 that are vertically stacked on the substrate 100. For example, the power gate electrode PGE may include an inner electrode interposed between the second channel patterns SP2 and an outer electrode on an uppermost second channel pattern SP2. A pair of gate spacers may be disposed on opposite sidewalls of the power gate electrode PGE. The gate spacers may extend in the first direction D1 along the dummy gate electrode DGE.

In one implementation, the gate electrode GE may include a lower gate electrode LGE comprising first inner electrode PO1, second inner electrode PO2, and third inner electrode PO3, and an upper gate electrode UGE comprising fourth inner electrode PO4, fifth inner electrode PO5, and outer electrode PO6.

The gate dielectric layer GI may be interposed between the power gate electrode PGE and the second channel patterns SP2. The gate dielectric layer GI may include one or more of a silicon oxide layer, a silicon oxynitride layer, and a high-k dielectric layer.

The lower separation pattern LDB may extend in the second direction D2 on the substrate 100. The lower separation pattern LDB may overlap the power gate electrode PGE. The lower separation pattern LDB may be disposed between the first lower source/drain pattern LSD1 and the second lower source/drain pattern LSD2. The lower separation pattern LDB may include a dielectric material, such as at least one selected from silicon oxide, silicon oxycarbide, silicon nitride, and a combination thereof.

The dummy pattern DSP may be disposed between the lower separation pattern LDB and the power gate electrode PGE.

On the substrate 100, the dummy gate electrode DGE may be disposed spaced apart in the first direction D1 from the lower separation pattern LDB.

The third channel patterns SP3 may be vertically stacked on the substrate 100, and the dummy gate electrode DGE may surround the third channel patterns SP3. A portion of the dummy gate electrode DGE may be interposed between the substrate 100 and the third channel pattern SP3 and between neighboring third channel patterns SP3.

The third channel patterns SP3 may include silicon (Si), germanium (Ge), or silicon-germanium (SiGe). For example, the third channel patterns SP3 may include crystalline silicon. Each of the third channel patterns SP3 may be a nano-sheet.

The upper separation pattern UDB may be spaced apart in the first direction D1 from the power gate electrode PGE, thereby being disposed on the dummy pattern DSP. The upper separation pattern UDB may extend in the second direction D2 parallel to the power gate electrode PGE. The upper separation pattern UDB may overlap the dummy gate electrode DGE. The upper separation pattern UDB may be in contact with the first upper source/drain pattern USD1. The upper separation pattern UDB may include a dielectric material, such as at least one selected from silicon oxide, silicon oxycarbide, silicon nitride, and a combination thereof.

The dummy pattern DSP may be disposed between the upper separation pattern UDB and the dummy gate electrode DGE.

A first upper active contact UAC1 may penetrate the second and third interlayer dielectric layer 120 and 130 to be coupled to the first upper source/drain pattern USD1, and a second upper active contact UAC2 may penetrate the second and third interlayer dielectric layers 120 and 130 to be coupled to the second upper source/drain pattern USD2.

The upper wiring layer UMS may be provided on the second interlayer dielectric layer 120, the power gate structure PGS, and the gate structures GS, and may include a second global power line VSSG and a first local power line VSS 1. The second global power line VSSG and the first local power line VSS 1 may extend along the first direction D1, and may be spaced apart from each other in the first direction D1. In one example, the first local power line VSS1 may be referred to as an upper local power line.

The second global power line VSSG may be connected to the first upper active contact UAC1 through the upper via UV (shown as UV1) and a first upper connection pattern UCM1. The first local power line VSS1 may be connected to the second upper active contact UAC2 through the upper via UV (shown as UV2) and a second upper connection pattern UCM2. The first and second upper connection pattern UCM1 and UCM2 may be disposed in the fourth interlayer dielectric layer 140, and may have a bar shape with a major axis in the second direction D2.

The through active contact TAC may penetrate the substrate 100, the second lower source/drain pattern LSD2, and the first interlayer dielectric layer 110, thereby being coupled to the second upper source/drain pattern USD2. The through active contact TAC may electrically connect the second upper source/drain pattern USD2 to the second lower source/drain pattern LSD2.

The second lower source/drain pattern LSD2 may be partially in direct contact with a sidewall of the through active contact TAC. The through active contact TAC may be disposed between the lower separation pattern LDB and the through separation pattern TDB. The through active contact TAC may include metal selected from copper (Cu), aluminum (Al), ruthenium (Ru), cobalt (Co), tungsten (W), and molybdenum (Mo).

The lower wiring layer LMS may include lower wiring lines LM and a second local power line VSS2. The lower wiring layer LMS may include first and second lower interlayer dielectric layers 210 and 220 stacked on the bottom surface of the substrate 100, lower wiring lines LM, and a second local power line VSS2.

The lower wiring lines LM and the second local power line VSS2 may extend in the first direction D1 on the second lower interlayer dielectric layer 220.

The lower wiring lines LM and the second local power line VSS2 may be disposed along the second direction D2 at a regular pitch. The second local power line VSS2 may be connected to the through active contact TAC through the lower via LV and the lower connection pattern LCM.

The following will now describe some implementations of the present disclosure in conjunction with the accompanying drawings. The components repetitive to those discussed above with reference to FIGS. 4A, 4B, and 5A to 5E will be allocated the same reference numerals, and a detailed description of related technical features thereof will be omitted.

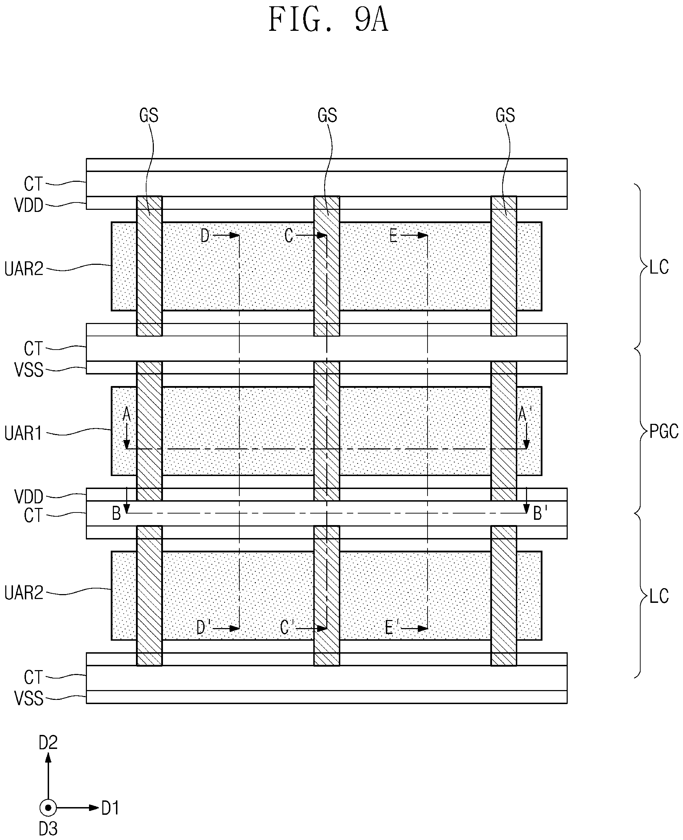

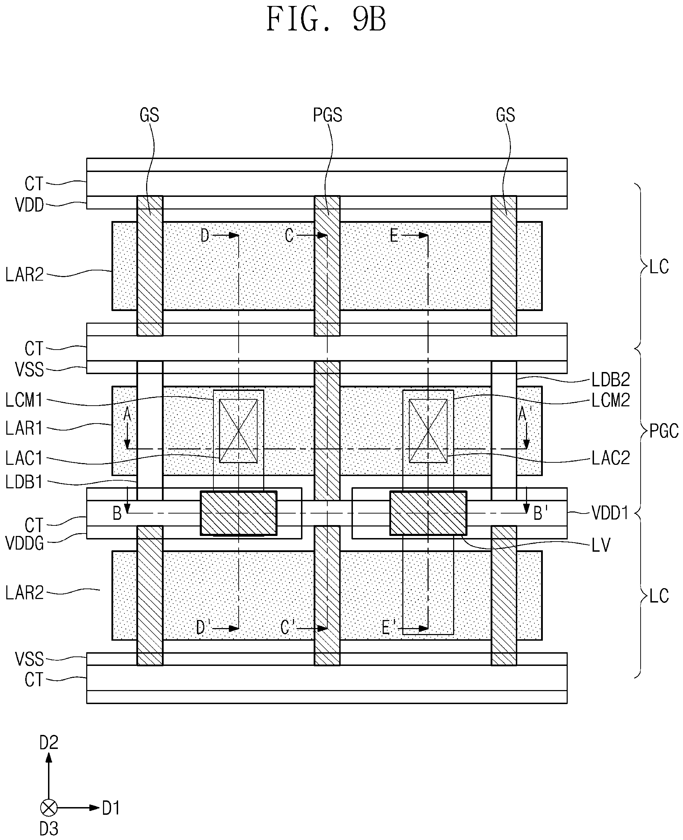

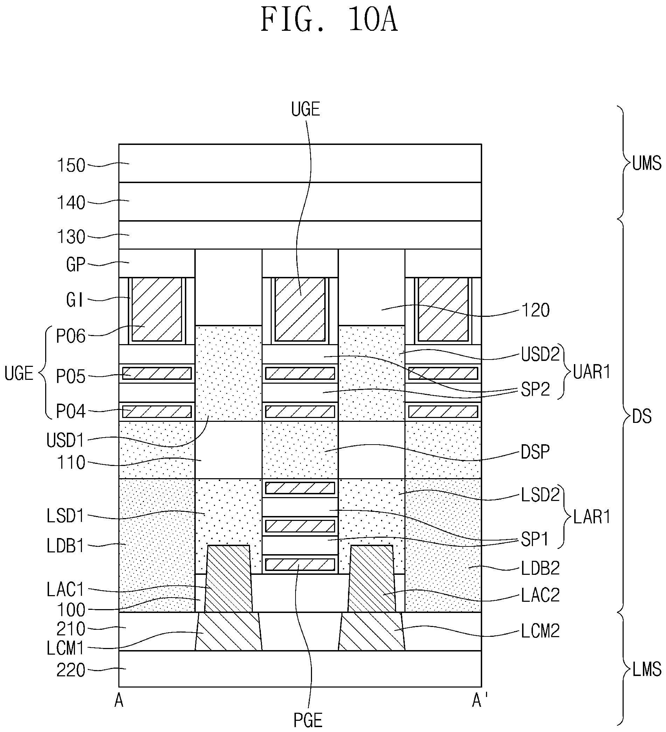

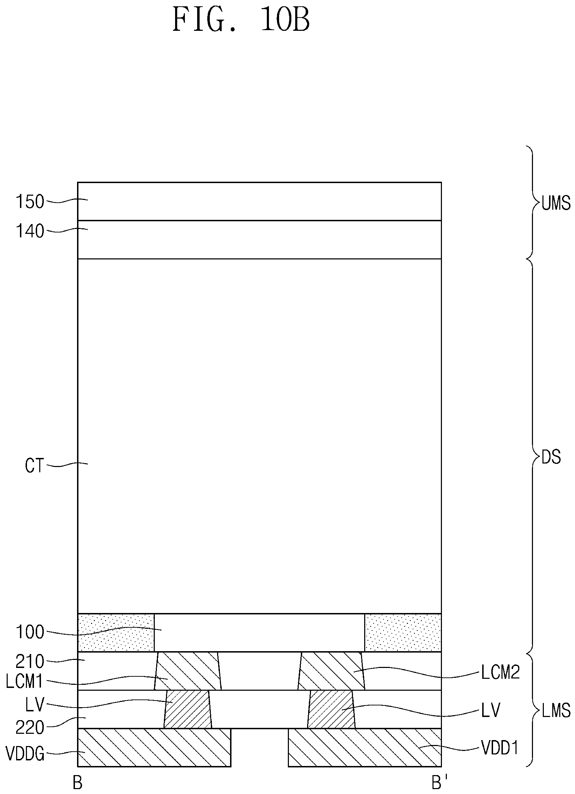

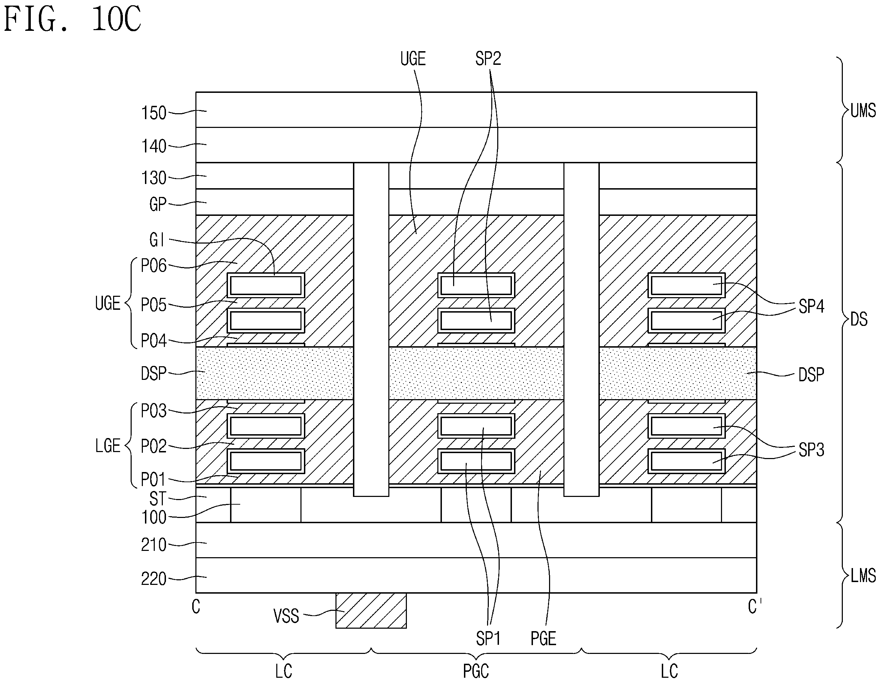

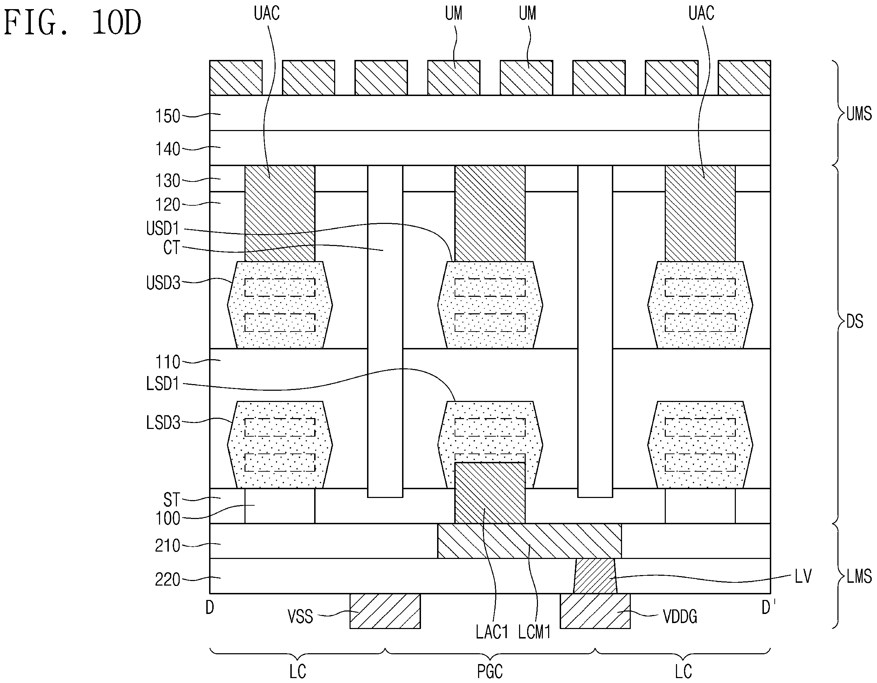

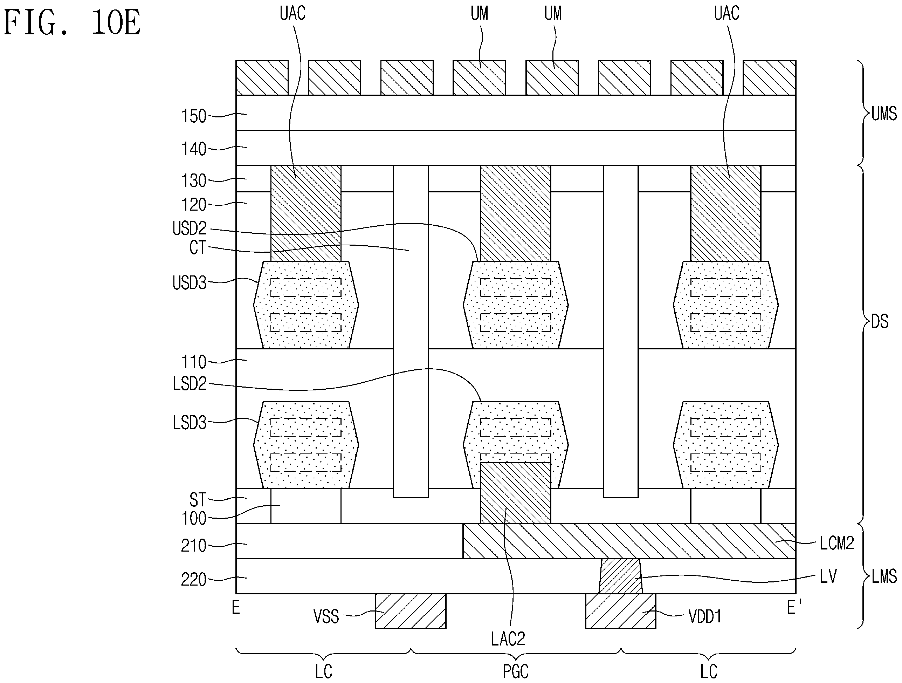

FIG. 9A illustrates a plan view showing an example of a semiconductor device including a power gating cell. FIG. 9B illustrates a bottom view showing an example of a semiconductor device including a power gating cell. FIGS. 10A, 10B, 10C, 10D, and 10E illustrate example cross-sectional views taken along lines A-A', B-B', C-C', D-D', and E-E' of FIGS. 9A and 9B.

Referring to FIGS. 9A, 9B, and 10A to 10E, the logic cell LC may be disposed on the power gating cell PGC. For example, the power gating cell PGC and the logic cell LC may overlap each other, and may be vertically separated from each other by the dummy pattern DSP.

On the substrate 100, the power gate electrode PGE may be disposed between first and second lower separation patterns LDB1 and LDB2. As discussed above, the power gate electrode PGE may extend along the second direction D2, while surrounding the first channel patterns SP1.

The first lower source/drain pattern LSD1 may be disposed between the first lower separation pattern LDB1 and the power gate electrode PGE, and the second lower source/drain pattern LSD2 may be disposed between the second lower separation pattern LDB2 and the power gate electrode PGE. As discussed above, the first and second lower source/drain patterns LSD1 and LSD2 may be connected to the first channel patterns SP1.

The second channel pattern SP2 may be vertically stacked on the first channel patterns SP1. The second channel pattern SP2 may overlap the first channel patterns SP1. In addition, the second channel patterns SP2 may be vertically stacked on the first lower separation pattern LDB 1 and the second lower separation pattern LDB2.

Upper gate electrodes UGE may be spaced apart from each other in the first direction D1 on the first upper active region UAR1. Each of the upper gate electrodes UGE may extend along the second direction D2, while surrounding the second channel patterns SP2.

A portion of the upper gate electrodes UGE may overlap the power gate electrode PGE, and may be electrically separated from each other by the dummy pattern DSP. A portion of the upper gate electrodes UGE may overlap the first lower separation pattern LDB1 and the second lower separation pattern LDB2.

The first and second lower active contacts LAC1 and LAC2 may penetrate the substrate 100 to be coupled to the first and second lower source/drain patterns LSD1 and LSD2, respectively. The first and second lower active contacts LAC1 and LAC2 may be buried in the substrate 100.

In the first lower interlayer dielectric layer 210, the first lower connection pattern LCM1 may be coupled to the first lower active contact LAC1, and in the first lower interlayer dielectric layer 210, the second lower connection pattern LCM2 may be coupled to the second lower active contact LAC2.

The first global power line VDDG may extend in the first direction D1 on the second lower interlayer dielectric layer 220, and may be connected through the lower via LV to the first lower connection pattern LCM1.

On the second lower interlayer dielectric layer 220, the first local power line VDD1 may be disposed spaced apart in the first direction D1 from the first global power line VDDG, and may extend along the first direction D1. The first local power line VDD1 may be connected through the lower via LV to the second lower connection pattern LCM2.

Upper active contacts UAC may be correspondingly coupled to the first and second upper source/drain patterns USD1 and USD2. The upper active contacts UAC may be electrically connected to the upper wiring lines UM provided on the upper wiring layer UMS.

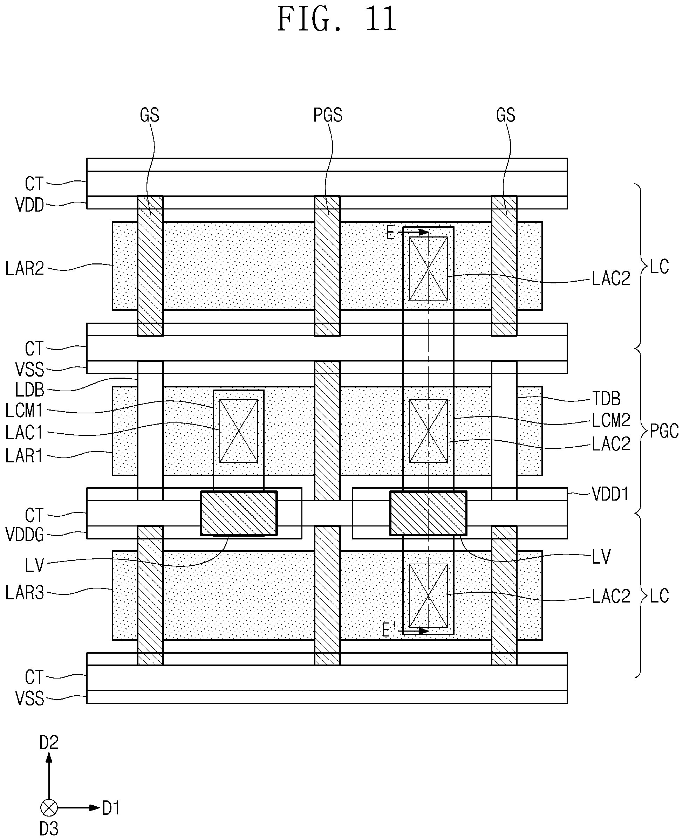

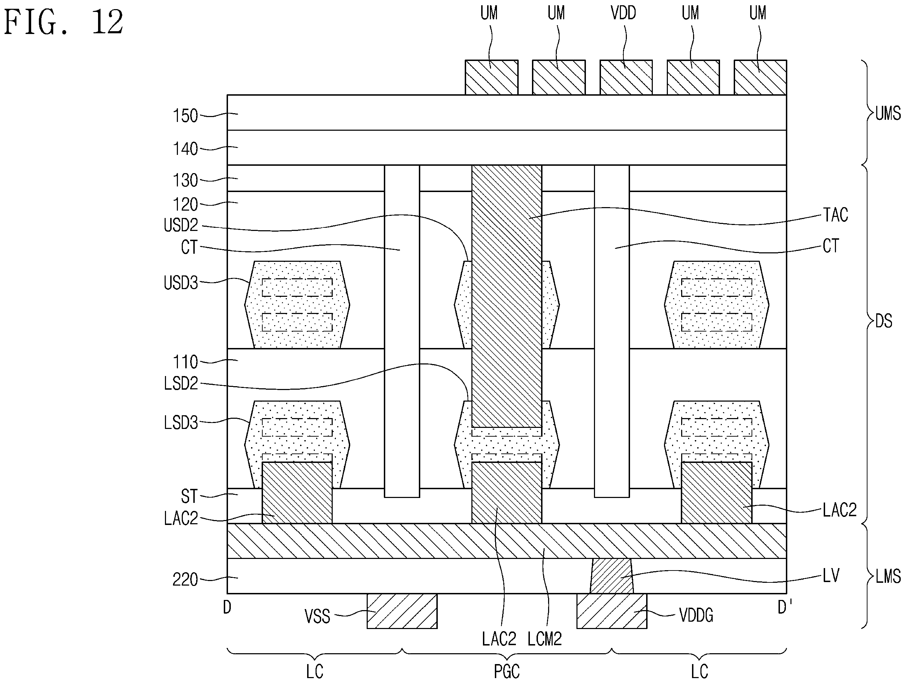

FIG. 11 illustrates a bottom view showing an example of a semiconductor device including a power gating cell. FIG. 12 illustrates an example cross-sectional view taken along line E-E' of FIG. 11.

Referring to FIGS. 11 and 12, the logic cells LC may be disposed adjacent in the second direction D2 to the power gating cell PGC.

On the substrate 100, the lower connection pattern LCM may extend in the second direction D2 and cross the first lower active region LAR1 and the second lower active region LAR2.

The lower connection pattern LCM may be electrically connected through the second lower active contacts LAC2 to the second lower source/drain pattern LSD2 of the logic cell LC and to the second lower source/drain pattern LSD2 of the power gating cell PGC. For example, the logic cell LC may be provided with a power voltage from the power gating cell PGC adjacent in the second direction D2 thereto.

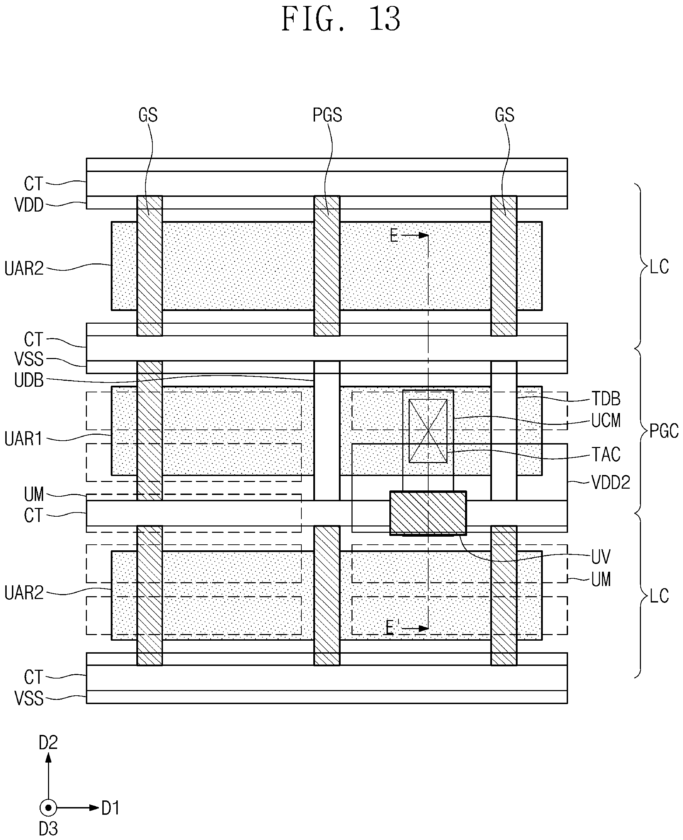

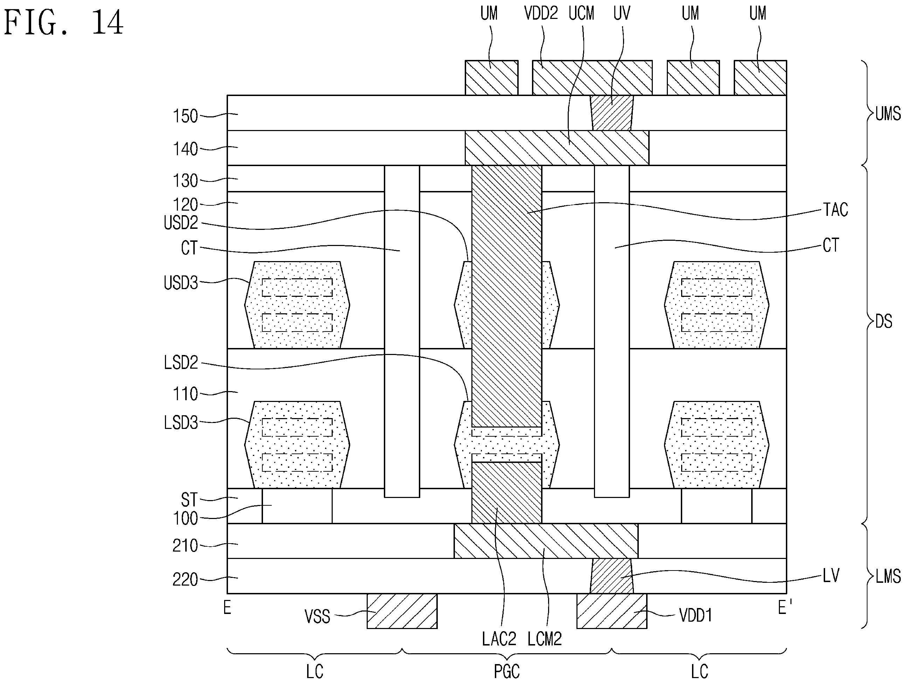

FIG. 13 illustrates a plan view showing an example of a semiconductor device including a power gating cell. FIG. 14 illustrates an example cross-sectional view taken along line E-E' of FIG. 13.

Referring to FIGS. 13 and 14, a semiconductor device may include a lower wiring layer LMS including lower wiring lines, an upper wiring layer UMS including upper wiring lines, and a device layer DS disposed between the lower wiring layer LMS and the upper wiring layer UMS.

The upper wiring layer UMS may be provided on the second interlayer dielectric layer 120, the power gate structure PGS, and the gate structures GS, and may include upper wiring lines UM and the second local power line VDD2.

The upper wiring lines UM may be disposed at a regular pitch on the fifth interlayer dielectric layer 150. When viewed in a plan view, the upper wiring lines UM may be disposed between the first and second lower power lines VSS and VDD.

The second local power line VDD2 may have a line-width greater than that of the upper wiring lines UM, and may be spaced apart in the first and second directions D1 and D2 from the upper wiring lines UM. As the second local power line VDD2 has a greater line-width than that of the upper wiring lines UM, it may be possible to reduce transmission delay of power voltage.

The second local power line VDD2 may be electrically connected through the upper via UV to the upper connection pattern UCM. For example, the second local power line VDD2 may be electrically connected to the second lower source/drain pattern LSD2 through the upper via UV, the upper connection pattern UCM.

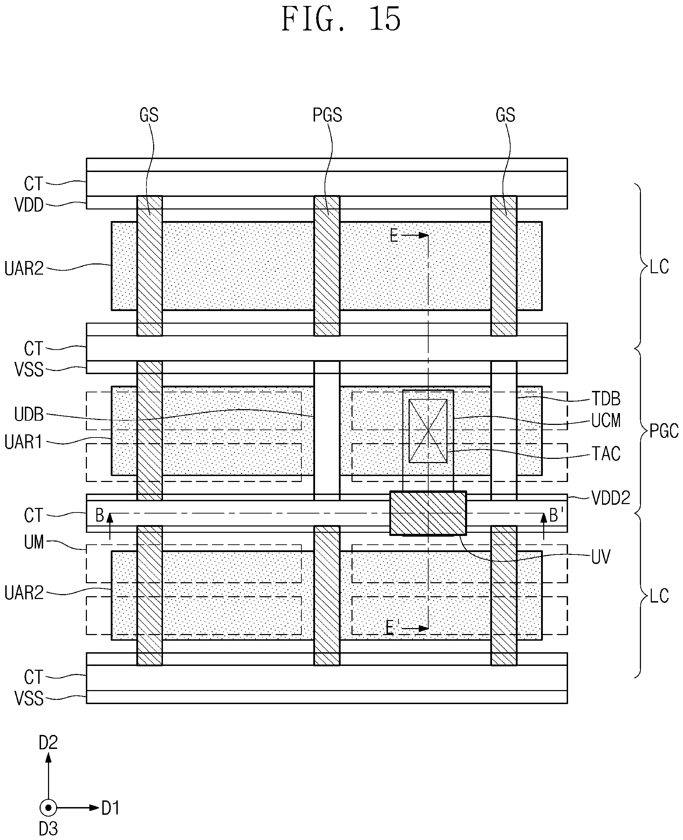

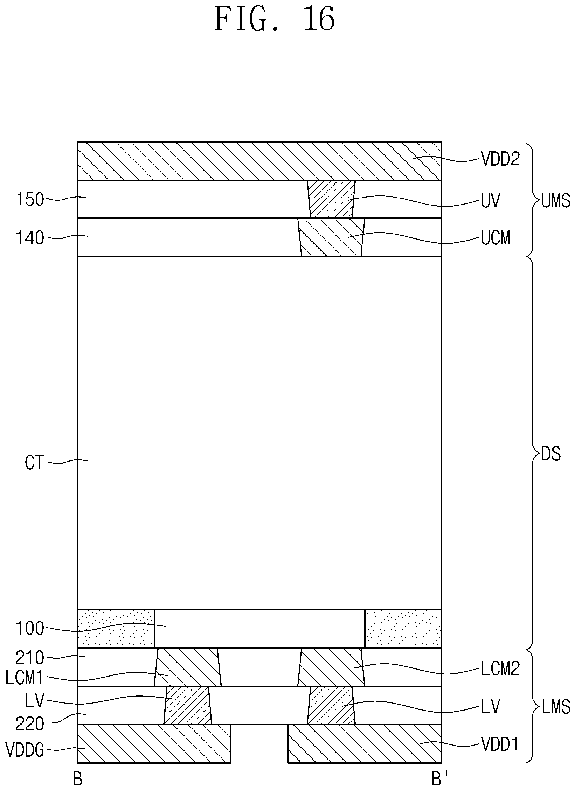

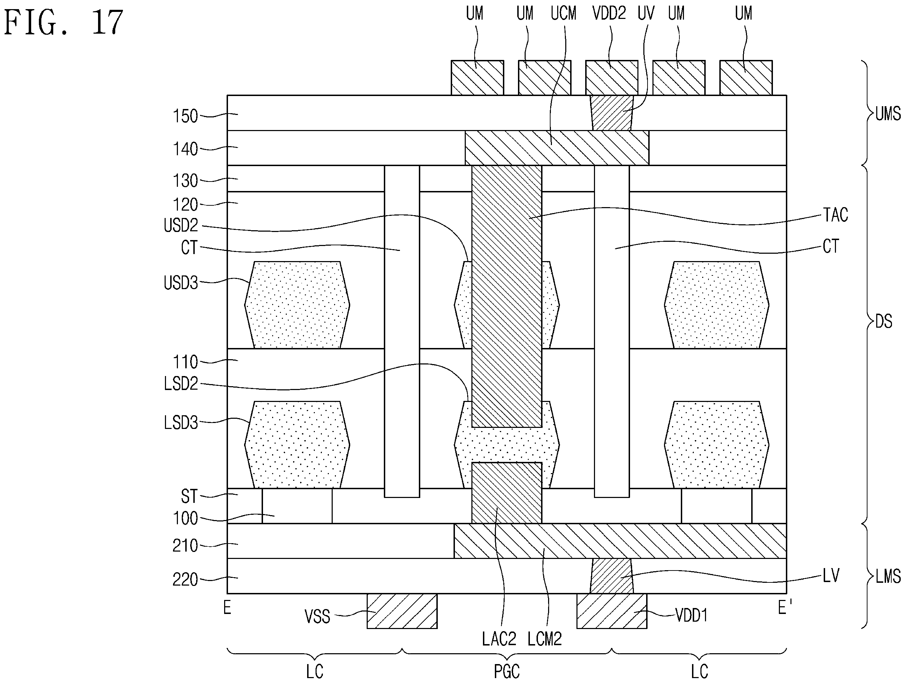

FIG. 15 illustrates a plan view showing an example of a semiconductor device including a power gating cell. FIG. 16 illustrates an example cross-sectional view taken along line B-B' of FIG. 15. FIG. 17 illustrates an example cross-sectional view taken along line E-E' of FIG. 15.

Referring to FIGS. 15, 16, and 17, a semiconductor device may include a lower wiring layer LMS including lower wiring lines, an upper wiring layer UMS including upper wiring lines, and a device layer DS disposed between the lower wiring layer LMS and the upper wiring layer UMS.

The lower wiring layer LMS may include first and second lower power lines VSS and VDD, a first global power line VDDG, and a first local power line VDD1. The upper wiring layer UMS may include upper wiring lines UM and a second local power line VDD2. As discussed above, the device layer DS may include logic cells LC and a power gating cell PGC.

On the upper wiring layer UMS, the second local power line VDD2 may have the same line-width as that of the upper wiring lines UM, and may continuously extend along the first direction D 1. The upper wiring lines UM may be spaced apart from each other in the first direction D1, and may be arranged along the second direction D2 at a regular pitch. The second local power line VDD2 may be connected to the through active contact TAC through the upper via UV and the upper connection pattern UCM.

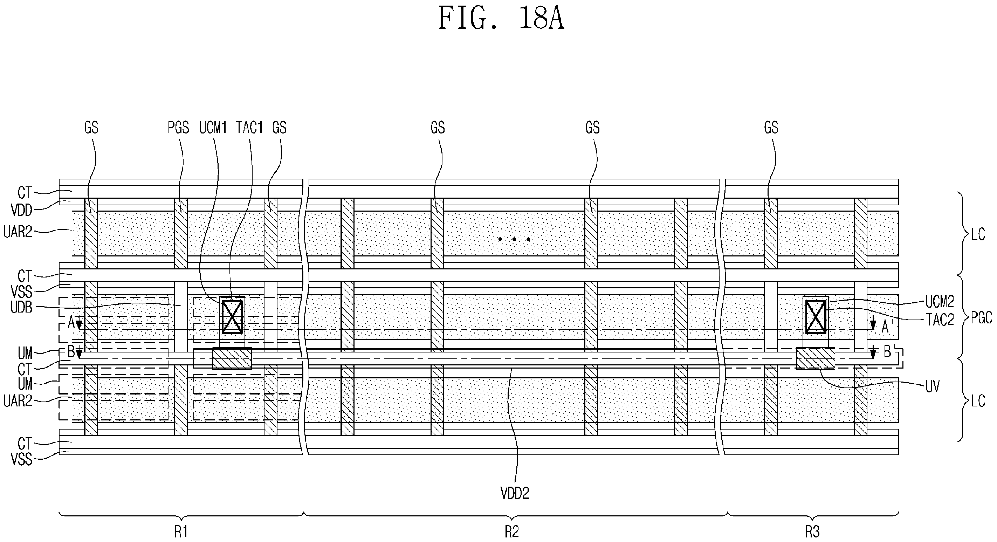

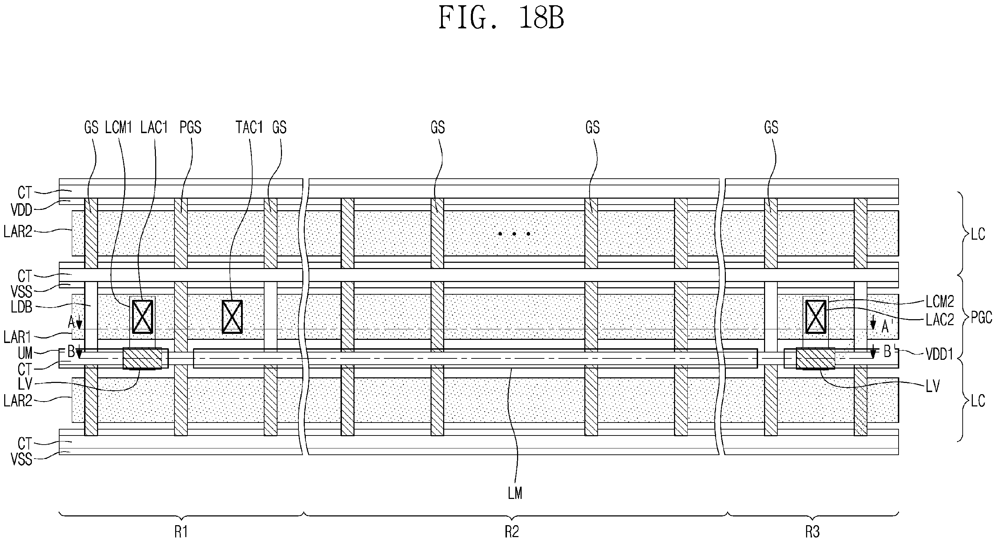

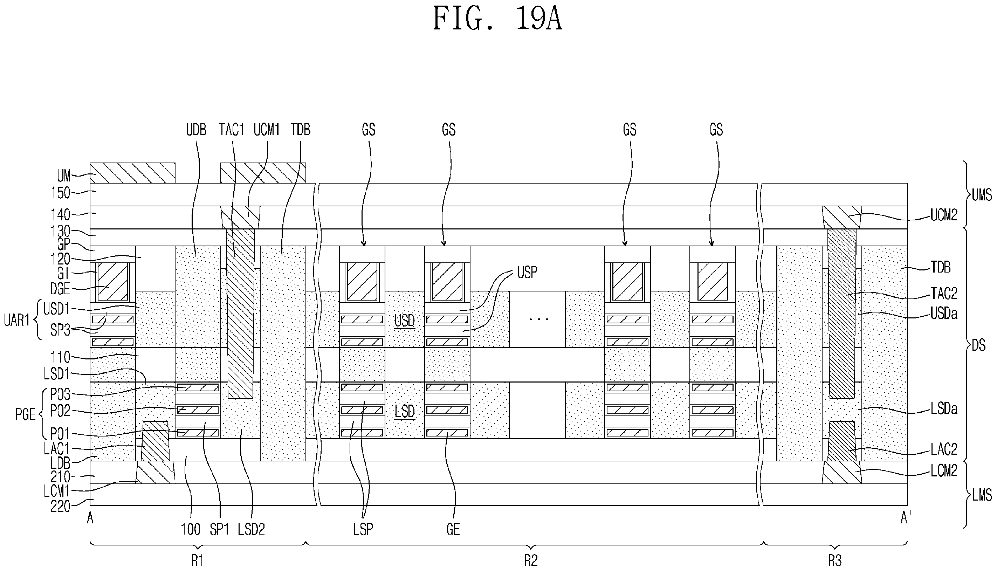

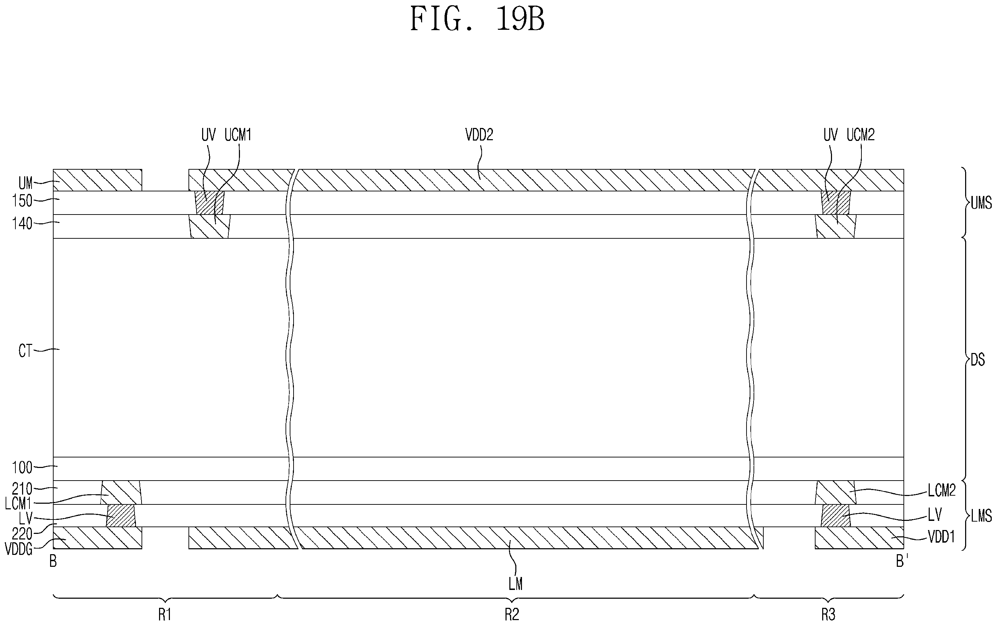

FIG. 18A illustrates a plan view showing an example of a semiconductor device including a power gating cell. FIG. 18B illustrates a bottom view showing an example of a semiconductor device including a power gating cell. FIGS. 19A and 19B illustrate example cross-sectional views taken along lines A-A' and B-B' of FIGS. 18A and 18B.

Referring to FIGS. 18A, 18B, 19A, and 19B, when viewed in a direction (or, a third direction D3) perpendicular to a top surface of a substrate 100, a semiconductor device may include a lower wiring layer LMS including lower wiring lines, an upper wiring layer UMS including upper wiring lines, and a device layer DS disposed between the lower wiring layer LMS and the upper wiring layer UMS.

According to some implementations, the semiconductor device may include a first region R1, a second region R2, and a third region R3 when viewed in a first direction D1 parallel to the top surface of the substrate 100.

On the first region R1, a power gating cell PGC may be provided between logic cells LC that are adjacent to each other in a second direction D2. On the second region R2, the logic cells LC may be provided along the first direction D1 and the second direction D2. On the third region R3, a first local power line VDD1 may be provided which is connected to the power gating cell PGC on the first region R1.

According to some implementations, the lower wiring layer LMS may include a global power line VDDG on the first region R1, a lower wiring line LM on the second region R2, and a first local power line VDD1 on the third region R3. The global power line VDDG, the lower wiring line LM, and the first local power line VDD1 may extend along the first direction D1, and may be spaced apart from each other in the first direction D1.

The upper wiring layer UMS may include upper wiring lines UM and a second local power line VDD2. The upper wiring lines UM and the second local power line VDD2 may extend along the first direction D1. The second local power line VDD2 may continuously extend along the first direction D1 from the first region R1 to the third region R3.

On the first region R1, the device layer DS may include the logic cells LC and the power gating cell PGC. The power gating cell PGC may include a first lower active region LAR1 on the substrate 100, a first upper active region UAR1 stacked on the first lower active region LAR1, and a power gate electrode PGE. The power gating cell PGC may be provided on the first lower active region LAR1 and may be formed of a PMOS transistor.

The first lower active region LAR1 may include a first lower source/drain pattern LSD1, a second lower source/drain pattern LSD2, and first channel patterns SP1 that connect the first lower source/drain pattern LSD1 to the second lower source/drain pattern LSD2. The power gate electrode PGE may extend along the first direction D1 parallel to the top surface of the substrate 100, and may surround the first channel patterns SP1.

The first upper active region UAR1 may include a first upper source/drain pattern USD1 and a second upper source/drain pattern USD2. An upper separation pattern UDB may be disposed between the first and second upper source/drain patterns USD1 and USD2.

A first lower active contact LAC1 may penetrate the substrate 100 to be coupled to the first lower source/drain pattern LSD1 of the power gating cell PGC. The first lower active contact LAC1 may be connected to the global power line VDDG through the first lower connection pattern LCM1 and the lower via LV.

The second lower source/drain pattern LSD2 of the power gating cell PGC may be electrically connected through a first through active contact TAC1, a first upper connection pattern UCM1, and an upper via UV to the second local power line VDD2 of the upper wiring layer UMS.

When viewed in a plan view, the second local power line VDD2 on the fifth interlayer dielectric layer 150 may pass through a plurality of logic cells LC provided on the second region R2 to continuously extend along the first direction D1. The second local power line VDD2 may be coupled to a second through active contact TAC2 through a second upper connection pattern UCM2 and an upper via UV on the third region R3.

On the second region R2, a plurality of gate structures GS may be arranged along the first direction D1 at a regular pitch.

Each of the gate structures GS may include a gate electrode GE that surrounds the lower channel patterns LSP and the upper channel patterns USP, a gate dielectric layer GI, a gate spacer, and a gate capping pattern GP. The lower channel patterns LSP and the upper channel patterns USP may be stacked spaced apart from each other in the third direction D3. Each of the gate structures GS may be disposed between the upper source/drain patterns USD and between the lower source/drain patterns LSD.

On the second region R2, the lower wiring line LM may be disposed on the second lower interlayer dielectric layer 220. On the third region R3, the first local power line VDD1 may be disposed on the second lower interlayer dielectric layer 220.

On the third region R3, the second through active contact TAC2 may electrically connect an upper source/drain pattern USDa to a lower source/drain pattern LSDa.

On the third region R3, the second lower active contact LAC2 may penetrate the substrate 100 to be coupled to a lower source/drain pattern LSDa. The second lower active contact LAC2 may be connected to the first local power line VDD1 through the second lower connection pattern LCM2 and the lower via LV.

On the third region R3, the upper source/drain pattern USDa and the lower source/drain pattern LSDa may be disposed in the first direction D1 between the through separation patterns TDB.

According to some implementations, a power gating cell may be provided in a structure where a PMOS transistor and an NMOS transistor are vertically stacked, and thus a semiconductor device may decrease in power consumption and increase in performance.

A through active contact may be utilized to place local power lines on upper and lower portions of the semiconductor device, there may be an increase in the degree of freedom of wiring lines for connection of logic cells from power gating cells. In one example, a through active contact is used to supply a power voltage to all of upper and lower sides. That is, front and back multi-VDD may be achieved simultaneously.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Embodiments are set out in the following clauses:
1. A semiconductor device, comprising: a lower wiring layer including a plurality of lower wiring lines; an upper wiring layer including a plurality of upper wiring lines; and a power gating cell between the lower wiring layer and the upper wiring layer, wherein the power gating cell includes: a first active region on a substrate, wherein the first active region includes a first lower source/drain pattern, a second lower source/drain pattern, and a first channel pattern that connects the first lower source/drain pattern and the second lower source/drain pattern with each other; a second active region on the first active region, wherein the second active region includes a first upper source/drain pattern and a second upper source/drain pattern; and a power gate electrode that surrounds the first channel pattern and extends in a first direction parallel to a top surface of the substrate, and wherein the lower wiring layer includes: a global power line connected with the first lower source/drain pattern; and a local power line connected with the second lower source/drain pattern.
Clause 2. The semiconductor device of clause 1, wherein the global power line and the local power line extend in a second direction that is parallel to the top surface of the substrate and intersects the first direction, and in a plan view, the global power line is spaced apart in the second direction from the local power line, and the power gate electrode is disposed between the global power line and the local power line.
Clause 3. The semiconductor device of clause 1 or 2, comprising a through active contact connecting the second lower source/drain pattern with the second upper source/drain pattern.
Clause 4. The semiconductor device of clause 3, wherein the upper wiring layer includes an upper local power line connected with the through active contact.
Clause 5. The semiconductor device of clause **4,** wherein a line-width of the upper local power line is greater than a line-width of the upper wiring lines.
Clause 6. The semiconductor device of any preceding clause, comprising: a first separation pattern that extends in the first direction parallel to the power gate electrode and contacts the first lower source/drain pattern; and a second separation pattern that extends in the first direction parallel to the power gate electrode and contacts the second lower source/drain pattern.
Clause 7. The semiconductor device of clause 6, wherein the second separation pattern extends vertically and contacts the second upper source/drain pattern.
Clause 8. The semiconductor device of clause 7, wherein the second active region includes a third separation pattern between the first upper source/drain pattern and the second upper source/drain pattern, and wherein the third separation pattern overlaps the power gate electrode.
Clause 9. The semiconductor device of clause 8, comprising a through active contact that connects the second lower source/drain pattern with the second upper source/drain pattern, and wherein the through active contact is between the second separation pattern and the third separation pattern.
Clause 10. The semiconductor device of clause 9, wherein the first separation pattern, the second separation pattern, and the third separation pattern include a dielectric material.
Clause 11. The semiconductor device of any preceding clause, comprising: an upper gate electrode that extends in the first direction and surrounds a second channel pattern, the second channel pattern connecting the first upper source/drain pattern and the second upper source/drain pattern with each other on the power gate electrode; and a dummy pattern between the power gate electrode and the upper gate electrode.
Clause 12. The semiconductor device of any preceding clause, comprising a logic cell adjacent to the power gating cell in the first direction, wherein the logic cell includes: a third channel pattern on the substrate; a fourth channel pattern on the third channel pattern; a plurality of third lower source/drain patterns on opposite sides of the third channel pattern; a plurality of fourth upper source/drain patterns on opposite sides of the fourth channel pattern; and a gate electrode that extends in the first direction and surrounds the third channel pattern and the fourth channel pattern.
Clause 13. The semiconductor device of clause 12, wherein the local power line is connected with one of the plurality of third lower source/drain patterns.
Clause 14. A semiconductor device, comprising: a first active region on a substrate, wherein the first active region includes a first lower source/drain pattern, a second lower source/drain pattern, and a first channel pattern that connects the first lower source/drain pattern and the second lower source/drain pattern with each other; a second active region on the first active region, wherein the second active region includes a first upper source/drain pattern and a second upper source/drain pattern; a power gate electrode that extends in a first direction parallel to a top surface of the substrate and surrounds the first channel pattern; a global power line on a bottom surface of the substrate and connected with the first lower source/drain pattern; a first local power line on the bottom surface of the substrate and connected with the second lower source/drain pattern; a through active contact that connects the second lower source/drain pattern with the second upper source/drain pattern; and a second local power line on the top surface of the substrate and connected with the through active contact.
Clause 15. The semiconductor device of clause 14, comprising: a first separation pattern that extends in the first direction parallel to the power gate electrode and contacts the first lower source/drain pattern; a second separation pattern that extends in the first direction parallel to the power gate electrode and contacts the second lower source/drain pattern and the second upper source/drain pattern; and a third separation pattern between the first upper source/drain pattern and the second upper source/drain pattern, the third separation pattern overlapping the power gate electrode.
Clause 16. The semiconductor device of clause 15, wherein the through active contact is between the second separation pattern and the third separation pattern.
Clause 17. The semiconductor device of clause 14 or 15, wherein, in a plan view, the global power line is spaced apart from the first local power line, and the power gate electrode is disposed between the global power line and the first local power line.
Clause 18. The semiconductor device of clause 17, comprising a plurality of gate electrodes between the global power line and the first local power line, wherein the second local power line extends in a second direction intersecting the first direction and crosses the plurality of gate electrodes.
Clause 19. The semiconductor device of any one of clauses 14 to 18, comprising: a first lower active contact between the global power line and the first lower source/drain pattern; and a second lower active contact between the first local power line and the second lower source/drain pattern.
Clause 20. A semiconductor device, comprising: a first active region on a substrate, wherein the first active region includes a first lower source/drain pattern, a second lower source/drain pattern, and a first channel pattern that connects the first and second lower source/drain patterns with each other; a second active region on the first active region, wherein the second active region includes a first upper source/drain pattern and a second upper source/drain pattern; a power gate electrode that extends in a first direction parallel to a top surface of the substrate and surrounds the first channel pattern; a first separation pattern spaced apart from the power gate electrode in a second direction and contacted the first lower source/drain pattern; a second separation pattern spaced apart from the power gate electrode in the second direction and contacted the second lower source/drain pattern and the second upper source/drain pattern; a third separation pattern between the first upper source/drain pattern and the second upper source/drain pattern and overlapping the power gate electrode; a dummy gate electrode that extends in the first direction and surrounds a second channel pattern on the first separation pattern; a global power line on a bottom surface of the substrate and connected with the first lower source/drain pattern; a first local power line on the bottom surface of the substrate and connected with the second lower source/drain pattern; a first lower active contact between the global power line and the first lower source/drain pattern; a second lower active contact between the first local power line and the second lower source/drain pattern; a through active contact that connects the second lower source/drain pattern with the second upper source/drain pattern; and a second local power line on the top surface of the substrate and connected with the through active contact.

Although the present disclosure has been described in connection with some implementations of the present disclosure illustrated in the accompanying drawings, it will be understood to those skilled in the art that various changes and modifications may be made without departing from the essential feature of the present disclosure. It will be apparent to those skilled in the art that various substitution, modifications, and changes may be thereto without departing from the scope of the present disclosure.

## Claims

1. A semiconductor device, comprising:
a lower wiring layer including a plurality of lower wiring lines;
an upper wiring layer including a plurality of upper wiring lines; and
a power gating cell between the lower wiring layer and the upper wiring layer,
wherein the power gating cell includes:
a first active region on a substrate, wherein the first active region includes a first lower source/drain pattern, a second lower source/drain pattern, and a first channel pattern that connects the first lower source/drain pattern and the second lower source/drain pattern with each other;
a second active region on the first active region, wherein the second active region includes a first upper source/drain pattern and a second upper source/drain pattern; and
a power gate electrode that surrounds the first channel pattern and extends in a first direction parallel to a top surface of the substrate, and
wherein the lower wiring layer includes:
a global power line connected with the first lower source/drain pattern; and
a local power line connected with the second lower source/drain pattern.

2. The semiconductor device of claim **1,** wherein
the global power line and the local power line extend in a second direction that is parallel to the top surface of the substrate and intersects the first direction, and
in a plan view, the global power line is spaced apart in the second direction from the local power line, and the power gate electrode is disposed between the global power line and the local power line.

3. The semiconductor device of claim 1 or 2, comprising a through active contact connecting the second lower source/drain pattern with the second upper source/drain pattern.

4. The semiconductor device of claim 3, wherein the upper wiring layer includes an upper local power line connected with the through active contact.

5. The semiconductor device of claim 4, wherein a line-width of the upper local power line is greater than a line-width of the upper wiring lines.

6. The semiconductor device of any preceding claim, comprising:
a first separation pattern that extends in the first direction parallel to the power gate electrode and contacts the first lower source/drain pattern; and
a second separation pattern that extends in the first direction parallel to the power gate electrode and contacts the second lower source/drain pattern.

7. The semiconductor device of claim 6, wherein the second separation pattern extends vertically and contacts the second upper source/drain pattern.

8. The semiconductor device of claim 6 or 7, wherein the second active region includes a third separation pattern between the first upper source/drain pattern and the second upper source/drain pattern, and
wherein the third separation pattern overlaps the power gate electrode.

9. The semiconductor device of claim 8, comprising a through active contact that connects the second lower source/drain pattern with the second upper source/drain pattern, and
wherein the through active contact is between the second separation pattern and the third separation pattern.

10. The semiconductor device of claim 8 or 9, wherein the first separation pattern, the second separation pattern, and the third separation pattern include a dielectric material.

11. The semiconductor device of any preceding claim, comprising:
an upper gate electrode that extends in the first direction and surrounds a second channel pattern, the second channel pattern connecting the first upper source/drain pattern and the second upper source/drain pattern with each other on the power gate electrode; and
a dummy pattern between the power gate electrode and the upper gate electrode.

12. The semiconductor device of any preceding claim, comprising a logic cell adjacent to the power gating cell in the first direction,
wherein the logic cell includes:
a third channel pattern on the substrate;
a fourth channel pattern on the third channel pattern;
a plurality of third lower source/drain patterns on opposite sides of the third channel pattern;
a plurality of fourth upper source/drain patterns on opposite sides of the fourth channel pattern; and
a gate electrode that extends in the first direction and surrounds the third channel pattern and the fourth channel pattern.

13. The semiconductor device of claim 12, wherein the local power line is connected with one of the plurality of third lower source/drain patterns.
